# EUROPÄISCHE PATENTSCHRIFT

(11) **EP 3 534 242 B1**
(45) Veröffentlichungstag und Bekanntmachung des Hinweises auf die Patenterteilung: **27.04.2022**
(21) Anmeldenummer: 19157863.2
(22) Anmeldetag: 18.02.2019
(51) Int. Cl.: G06F 3/01, G01L 1/14, H03K 17/975, G06F 3/02

(54) **FLEXIBLES, TRAGBARES HANDBEDIENELEMENT ZUR STEUERUNG EINER ELEKTRISCH STEUERBAREN VORRICHTUNG UND VERWENDUNGEN HIERVON**
FLEXIBLE PORTABLE HANDLING ELEMENT FOR CONTROLLING AN ELECTRICALLY CONTROLLABLE DEVICE AND USES THEREOF
ÉLÉMENT DE COMMANDE MANUELLE FLEXIBLE, PORTATIVE PERMETTANT DE COMMANDER UN DISPOSITIF À COMMANDE ÉLECTRIQUE ET UTILISATIONS CORRESPONDANTES

(30) Priorität: 02.03.2018 DE 102018203193
(43) Veröffentlichungstag der Anmeldung: 04.09.2019
(73) Patentinhaber: Fraunhofer-Gesellschaft zur Förderung der angewandten Forschung e.V., 80686 München (DE)
(72) Erfinder: Böse, Holger, 97082 Würzburg (DE); Stier, Simon, 97082 Würzburg (DE); Ehrlich, Johannes, 97082 Würzburg (DE); Thuy, Maximilian, 97082 Würzburg (DE); Müller, Dominik, 97082 Würzburg (DE)
(74) Vertreter: Pfenning, Meinig & Partner mbB

(56) Entgegenhaltungen:
- EP-A1- 2 818 964
- EP-A2- 2 698 616
- GB-A- 2 456 942
- US-A1- 2006 061 555
- US-A1- 2016 187 973
- BÖSE HOLGER ET AL: "Applications of pressure-sensitive dielectric elastomer sensors", PROCEEDINGS OF SPIE; [PROCEEDINGS OF SPIE ISSN 0277-786X VOLUME 10524], SPIE, US, Bd. 9798, 15. April 2016 (2016-04-15), Seiten 97982C-97982C, XP060070762, DOI: 10.1117/12.2220808 ISBN: 978-1-5106-1533-5

## Beschreibung

Es wird ein flexibles, tragbares Handbedienelement zur Steuerung einer elektrisch steuerbaren Vorrichtung bereitgestellt. Das Handbedienelement enthält mindestens einen Sensor, der zur Detektion von elektrischen Widerständen geeignet ist und/oder mindestens eine Sensor, der zur Messung von elektrischen Kapazitäten geeignet ist. Ferner enthält das Handbedienelement eine elektronische Steuerungseinheit und eine Kommunikationsschnittstelle. Mit dem einfach aufgebauten und kostengünstig herstellbaren Handbedienelement ist eine feine und vielseitige Steuerung einer elektrisch steuerbaren Vorrichtung möglich, die auch über einen langen Zeitraum komfortabel und ohne Risiko einer Unterbrechung der Steuerung durchführbar ist. Es wird zudem ein Kit bereitgestellt, der das erfindungsgemäße Handbedienelement und eine elektrisch steuerbare Vorrichtung enthält. Ferner werden Verwendungen des erfindungsgemäßen Handbedienelements vorgeschlagen.

Zum Bedienen von elektronischen Geräten sowie von Maschinen in vielen technischen Umgebungen wird eine Vielzahl von Bedienelementen benötigt. Dieser sogenannten Mensch-Maschine-Schnittstelle (HMI = "Human Machine Interface") kommt wegen der steigenden Zahl von steuerbaren Funktionen eine wachsende Bedeutung zu. Als Beispiel für die Vielfalt von Bedienfunktionen sei hier das Automobil genannt. Zur Bedienung einfacher Funktionen wie Beleuchtung, Hupe oder Fensterheber kommen immer mehr komplexe steuerbare Systeme wie Klimatisierung, Navigation und Entertainment hinzu.

Darüber hinaus sind Steuer- und Bedienelemente auch in vielen anderen technischen Systemen notwendig. Die Steuerung vieler Maschinen erfolgt über geeignete Benutzeroberflächen. Elektronische Geräte brauchen für die Benutzung auf ihre Funktionen abgestimmte Bedienelemente. Das betrifft nicht nur Computer, sondern auch Smartphones, Spielekonsolen und viele weitere Klassen von elektronischen Geräten. Eine zunehmende Bedeutung erhält auch die einfache Bedienung von Robotern, sowohl in der Industrie als auch im Haushalt. Für eine intuitive Bewegungsvorgabe werden mit der Hand steuerbare Bedienoberflächen benötigt.

Bei der Gerätebedienung ist zwischen verschiedenen Arten der Beeinflussung zu unterscheiden. Das einfachste Bedienelement ist ein Schalter, der eine gewünschte Funktion, wie z. B. Licht, ein- und ausschaltet. Eine komplexere Bedienmöglichkeit verlangt die Steuerung oder Einstellung einer Stellgröße, wie beispielsweise einer Helligkeit oder einer Lautstärke. Noch komplexer ist die Einstellung einer mehrdimensionalen Stellgröße. Ein Beispiel hierfür stellt die Steuerung eines Spiegels dar, der in zwei Achsen verstellt werden kann. Ein anderes Beispiel ist die Computer-Maus, die den Cursor auf dem Bildschirm in der Ebene positioniert.

Eine noch am Anfang stehende Entwicklung ist die Integration von Elektronik in Kleidung. Wenn auch Bedienelemente in Textilien eingebunden werden sollen, müssen sie eine flache Form aufweisen und nach Möglichkeit weich und flexibel ausfallen, um einen hohen Tragekomfort zu bieten.

Entsprechend dem hohen Bedarf steht bereits eine große Auswahl von Steuer- und Bedienelementen zur Verfügung. Zum einfachen Schalten werden überwiegend Druck-, Kipp- oder auch Drehschalter eingesetzt. Zur Einstellung einer Stellgröße können Dreh- oder Schieberegler verwendet werden. Eine, besonders durch die digitale Elektronik, inzwischen häufig genutzte Bedienmethode besteht darin, die Stellgröße über ein mehrfach wiederholtes, oder eine definierte Zeit anhaltendes, Drücken eines Drucktasters einzustellen. Auf diese Weise werden beispielsweise die Elektromotoren zur Verstellung der Außenspiegel im Fahrzeug gesteuert. Eine solche Einstellung kann jedoch relativ zeitaufwendig werden.

Für komplexere, z.B. zweidimensionale, Einstellungen mit hoher Geschwindigkeit stehen beispielsweise Joysticks zur Verfügung. Auch die Computer-Maus erfüllt eine derartige Funktion. Dabei handelt es sich jedoch schon um relativ aufwendige Geräte mit hohem Platzbedarf. Auch Touch-Displays, die besonders in Smartphones weit verbreitet sind, ermöglichen eine zweidimensionale Steuerung. Komplexe Steuerbefehle können über eine Tastatur eingegeben werden. Dies ist auch mit einem Touch-Display möglich.

Wegen der damit verbundenen Berührung einer starren Glasplatte mit den Fingern ist damit jedoch keine Wahrnehmung einer mechanischen Nachgiebigkeit bei der Ausübung von Druckkräften verbunden. Bei den heute eingesetzten Steuer- und Bedienelementen handelt es sich in der Regel um starre Komponenten. Sie werden meist aus metallischen und nicht flexiblen Kunststoff-Bauteilen gefertigt. Dementsprechend können sie in ihrer Form nachträglich nicht mehr verändert und angepasst werden. Für einen Einsatz in Textilien gibt es bislang kaum geeignete Bedienelemente.

Neben der manuellen Steuerung von technischen Funktionen entstehen auch vermehrt andere Steuertechnologien. Exemplarisch sei hier die Gestensteuerung genannt. Dabei wird beispielsweise eine Kamera eingesetzt, die etwa Armbewegungen verfolgt. Eine geeignete Software wertet die Bilder aus und interpretiert die Bewegungen, um damit eine technische Funktion zu steuern und ggf. einen Vorgang auszulösen. Die Erfassung der Bedienung durch eine Person mittels einer Kamera ist jedoch wegen des Eingriffs in die Persönlichkeitssphäre umstritten und häufig nicht die bevorzugte Lösung.

Eine weitere Möglichkeit bietet die Sprachsteuerung, doch auch dieser Eingabe sind durch Verständnisprobleme und die mit der Sprache verbundenen akustischen Störung der Umgebung Grenzen gesetzt.

In der DE 10 2016 107 533 A1 wird eine Klasse von kapazitiven Steuer- und Bedienelementen beschrieben, die überwiegend oder vollständig aus elastomeren Komponenten aufgebaut sind. Damit wird es möglich, die Steuer- und Bedienelemente flexibel, d. h. biegbar, und bei Bedarf sogar dehnbar auszulegen. Die elementaren Grundfunktionen der in dieser Offenlegungsschrift beschriebenen Steuer- und Bedienelemente bestehen darin, dass durch die Anwendung einer definierten Kraft mit den Fingern eine Stellgröße auf den gewünschten Wert eingestellt werden kann und sofort anschließend ein Auslösevorgang mit den Fingern erfolgt, wodurch der gewünschte Wert der Stellgröße übernommen wird. Erwähnt wird dabei auch die Integration von Steuer- und Bedienelementen in Textilien. Ferner wird offenbart, die dielektrischen Elastomersensoren für Steuer-und Bedienelemente zu verwenden, wobei hierbei mit den Fingern einer Hand eine Verformung des Steuer- und Bedienelements erzeugt wird, die zu einer messbaren Kapazitätsveränderung führt. Mit steigender Fingerkraft werden die Verformung und damit auch die Kapazitätsveränderung größer. Wird die Kraft zurückgenommen, so werden auch die Verformung und die Kapazitätsveränderung wieder kleiner.

Dielektrische Elastomersensoren (DES) existieren in verschiedenen Versionen und werden dazu genutzt, Dehnungen, Zug- oder Druckkräfte zu messen. Die einfachste Version eines DES ist eine dielektrische Elastomerfolie. Eine dielektrische Elastomerfolie besteht aus einer stark dehnbaren Elastomerfolie, die beidseitig mit ebenfalls stark dehnbaren Elektroden beschichtet ist. Die Elektroden behalten auch bei hoher Dehnung eine ausreichende elektrische Leitfähigkeit bei. Eine solche dielektrische Elastomerfolie hat damit die Form eines Kondensators, dessen Kapazität von der Fläche der Elektroden und der Dicke der dazwischen liegenden Elastomerfolie abhängt. Wird die dielektrische Elastomerfolie gedehnt, so vergrößert sich die Fläche und verringert sich der Elektrodenabstand. Beides führt zu einer Erhöhung der Kapazität. Damit wirkt die dielektrische Elastomerfolie wie ein kapazitiver Dehnungssensor, mit dem auch Zugkräfte gemessen werden können.

Grundsätzlich können kapazitive Dehnungssensoren auch für Steuervorgänge in einem Handschuh verwendet werden. Ein wesentlicher Nachteil eines solchen Ansatzes besteht allerdings darin, dass die Steuerung einer technischen Funktion durch die Krümmung eines Fingers nicht präzise ist, da eine exakte Krümmungsbewegung schwer kontrollierbar ist. Ein weiterer Nachteil ist die relativ geringe Kapazitätsänderung infolge der geringen Dehnung der dielektrischen Elastomerfolie bei der Fingerkrümmung. Außerdem kann das am Finger befindliche Handbedienelement bei der Krümmung des Fingers verrutschen, was ebenfalls die genaue Einstellung einer definierten Dehnung der dielektrischen Elastomerfolie erschwert.

Kapazitive Drucksensoren sind bereits im Stand der Technik bekannt (EP 2 698 616 A2). Der Grundgedanke bei diesen kapazitiven Drucksensoren besteht darin, dass ein Schichtverbund aus einer planaren Elastomerfolie und ein oder zwei mit Oberflächenprofilen versehenen Elastomerfolien beim Zusammendrücken Verformungen erfährt, die zu einer deutlichen Erhöhung der gemessenen Kapazität führen. Dabei kommt der Position der leitfähigen Elektrodenschichten in dem Schichtverbund eine entscheidende Bedeutung zu. Für solche Drucksensoren bestehen vielfältige Designmöglichkeiten, mit denen sich die Empfindlichkeit in einem weiten Rahmen einstellen lässt.

In der US 2017/0025106 A1 wird eine Piano-Steuerung beschrieben, bei der Sensoren auf eine Hand montiert sind. Über drucksensitive Widerstandsmessungen wird dabei der Kontakt der Hand mit einer Oberfläche registriert.

Die US 2016/0187973 A1 offenbart ein Handbedienelement, das einen kapazitiven Drucksensor und einen resistiven Temperatursensor aufweist.

Ferner ist aus Böse, H. et al., Proceedings of Spie, Bd. 9798, S. 97982C-1-97982C-13 (DOI 10.1117/12.2220808) ein einfacher Handschuh bekannt, der einen kapazitiven Drucksensor aufweist.

Die US 2006/061555 A1 offenbart ein Handschuh-Handbedienelement, das ähnliche Funktionen wie z. B. eine Standard-Computertastatur aufweisen kann.

Die GB 2 456 942 A offenbart eine Vorrichtung zum Eingeben von Informationen in ein elektronisches Gerät, wobei die Vorrichtung einen ersten Sensor umfasst, der am Daumen eines Benutzers angebracht ist, und eine Vielzahl von zweiten Sensoren umfasst, die an den Fingern des Benutzers angebracht sind, so dass der Benutzer den ersten Sensor mit mindestens einem der Vielzahl der zweiten Sensoren kontaktieren kann.

Ausgehend hiervon war es die Aufgabe der vorliegenden Erfindung, ein flexibles, an der Hand tragbares Handbedienelement bereitzustellen, das einfach aufgebaut und kostengünstig herstellbar ist und eine feine und vielseitige Steuerung einer elektrisch steuerbaren Vorrichtung erlaubt, die auch über einen langen Zeitraum komfortabel und ohne Risiko einer Unterbrechung möglich ist.

Die Aufgabe wird gelöst durch den Handschuh mit den Merkmalen von Anspruch 1, den Kit mit den Merkmalen von Anspruch 12 und die Verwendung des Handschuhs mit den Merkmalen von Anspruch 13. Die abhängigen Ansprüche zeigen vorteilhafte Ausgestaltungen auf.

Erfindungsgemäß wird ein flexibles, (an der Hand) tragbares (und befestigbares) Handbedienelement zur Steuerung einer elektrisch steuerbaren Vorrichtung bereitgestellt, enthaltend
a) mindestens einen Sensor,
   wobei der mindestens eine Sensor zur Detektion von elektrischen Widerständen geeignet ist, ausgewählt ist aus der Gruppe bestehend aus resistiver Näherungssensor, resistiver Schersensor und Kombinationen hiervon, und eine erste und eine zweite elektrisch leitfähige Elektrodenschicht aufweist, wobei die zweite Elektrodenschicht in einer Zone des tragbaren Handbedienelements angeordnet ist, die verschieden ist zu einer Zone des tragbaren Handbedienelements, in welcher die erste Elektrodenschicht angeordnet ist, wobei die zweite Elektrodenschicht dazu geeignet ist, durch eine Bewegung des Handbedienelements über die erste Elektrodenschicht angeordnet zu werden; und/oder
   wobei der mindestens eine Sensor zur Messung von elektrischen Kapazitäten geeignet ist, ausgewählt ist aus der Gruppe bestehend aus kapazitiver Näherungssensor, kapazitiver Schersensor und Kombinationen hiervon, und eine erste und eine zweite elektrisch leitfähige Elektrodenschicht und eine Dielektrikumschicht aufweist, wobei die zweite Elektrodenschicht in einer Zone des tragbaren Handbedienelements angeordnet ist, die verschieden ist zu einer Zone des tragbaren Handbedienelements, in welcher die erste Elektrodenschicht angeordnet ist, wobei die zweite Elektrodenschicht dazu geeignet ist, durch eine Bewegung des Handbedienelements über die erste Elektrodenschicht dergestalt angeordnet zu werden, dass die Dielektrikumschicht zwischen der ersten und zweiten Elektrodenschicht (2) angeordnet ist;
   b) eine elektronische Steuerungseinheit, die dazu konfiguriert ist, mindestens eine vom Sensor detektierte elektrische Kapazität und/oder mindestens einen vom Sensor detektierten elektrischen Widerstand in ein Steuersignal zur Steuerung der elektrisch steuerbaren Vorrichtung umzuwandeln; und
   c) eine Kommunikationsschnittstelle, die dazu konfiguriert ist, ein Steuersignal der elektronischen Steuerungseinheit an die elektrisch steuerbare Vorrichtung zu senden,
   wobei das tragbare Handbedienelement eine erste Zone und eine zweite Zone aufweist, wobei die erste und zweite Zone jeweils zur zumindest teilweisen Bedeckung eines Fingers oder einer Handinnenfläche eines Benutzers geeignet sind, an unterschiedlichen Stellen des Handbedienelements angeordnet sind und für die Herstellung eines Steuersignals nötig sind, wobei der mindestens eine Sensor teilweise in der ersten Zone und teilweise in der zweiten Zone angeordnet ist, wobei die erste Zone zur zumindest teilweisen Bedeckung einer Fläche eines ersten Fingers eines Benutzers geeignet ist und die zweite Zone zur zumindest teilweisen Bedeckung einer Fläche eines zweiten Fingers, oder der Handinnenfläche, derselben Hand eines Benutzers geeignet ist,
   wobei für den Fall, dass der mindestens eine Sensor ein kapazitiver Schersensor oder ein resistiver Schersensor ist, der mindestens eine Sensor ferner eine dritte elektrisch leitfähige Elektrodenschicht aufweist, die in einer Zone des tragbaren Handbedienelements angeordnet ist, die zur zumindest teilweisen Bedeckung eines Fingers oder einer Handinnenfläche eines Benutzers geeignet ist und wobei diese Zone i) identisch ist mit einer Zone des tragbaren Handbedienelements, in welcher die erste Elektrodenschicht angeordnet ist, oder ii) identisch ist mit einer Zone des tragbaren Handbedienelements, in welcher die zweite Elektrodenschicht angeordnet ist,
   dadurch gekennzeichnet, dass der mindestens eine Sensor so ausgestaltet ist, dass sich bei einer Annäherung der ersten Zone an die zweite Zone bis zur Berührung, und auch bei der anschließenden Druckausübung, die Kapazität bzw. der Widerstand in definierter Weise in Abhängigkeit vom Abstand verändert.

Das flexible, tragbare Handbedienelement ist dazu geeignet, zumindest bereichsweise mit Teilen (z.B. einem Finger oder der Handinnenseite) einer Hand (z.B. einer menschlichen Hand) verbunden zu werden. Hierbei kann das Handbedienelement dazu geeignet sein, zumindest bereichsweise einen Teil einer Hand zu umschließen. Das Handbedienelement kann ferner dazu geeignet sein, mit einem Teil einer Hand verbunden zu werden (z.B. über eine mechanische Verbindung). Das Handbedienelement ist bevorzugt zumindest bereichsweise als Handschuh ausgestaltet (z.B. ein Handbedienelement als vollständiger Handschuh oder ein Handbedienelement, das nicht alle Finger der Hand umschließt).

Ein wesentlicher Vorteil des erfindungsgemäßen Handbedienelements besteht darin, dass eine Hand wie die menschliche Hand mit ihren vielen Fingergelenken eine enorme Vielseitigkeit von Bewegungen erlaubt. Mechanisch betrachtet bedeutet das, dass die menschliche Hand Bewegungen mit einer großen Zahl von Freiheitsgraden ausführen kann. Daraus resultiert eine entsprechend hohe Variabilität von möglichen Eingabebefehlen durch Bewegungen mit der Hand. Der besondere Vorteil in der Steuerung einer elektrisch steuerbaren Vorrichtung über das erfindungsgemäße Handbedienelement besteht darin, dass durch das Tragen des Handschuhs ein Halten bzw. Greifen einer anders ausgestalteten Steuervorrichtung (z.B. einer klassischen Fernbedienung) mit der Hand entfällt und die Hände damit für andere Tätigkeiten frei bleiben. Ferner kann das erfindungsgemäße Handbedienelement von einem Benutzer einfach getragen (d.h. angezogen) werden, was den Trageaufwand reduziert und zudem vermeidet, dass das Handbedienelements versehentlich aus der Hand gleitet und damit die Steuerungsmöglichkeit der elektrisch steuerbaren Vorrichtung unbeabsichtigt unterbrochen wird. Weitere Vorteile liegen darin, dass der Aufbau des erfindungsgemäßen Handbedienelements einfach und kostengünstig ist und somit die Herstellungskosten gering sind.

Das erfindungsgemäße Handbedienelement kann eine Verformung der Hand durch Relativbewegungen der Finger detektieren. Damit besteht ein Unterschied zu Handbedienelementen, welche über Sensoren nur die Position der Hand erfassen und die Bewegung der ganzen Hand verfolgen (z.B. Handschuhe mit Beschleunigungssensoren zum Tracking). Anders als bei einem Handbedienelement mit Beschleunigungssensoren kann das erfindungsgemäße Handbedienelement eine Bewegung von Teilen der Hand (z.B. Finger der Hand) relativ zueinander bis zur Berührung und einem nachfolgenden Zusammendrücken erfassen. Mit dem erfindungsgemäßen Handbedienelement können somit Steuersignale für eine elektrisch steuerbare Vorrichtung nicht nur durch Bewegungen der Finger einer Hand im Raum, sondern auch durch Bewegungen der Finger einer Hand zueinander bis zur Berührung und einem nachfolgenden Zusammendrücken, gezielt generiert werden und als Stellgröße an eine elektrisch steuerbare Vorrichtung übermittelt werden. Das Steuersignal kann dann von der elektrisch steuerbaren Vorrichtung empfangen und übernommen werden. Mit dem erfindungsgemäßen Bedienelement lassen sich auch mehrdimensionale Stellgrößen generieren.

Wird das erfindungsgemäße Bedienelement von einem Benutzer verwendet, so kann eine definierte Bewegung eines Fingers des Benutzers eine Änderung des elektrischen Widerstands und/oder der elektrischen Kapazität des mindestens einen Sensors bewirken, der in der Zone des bewegten Fingers angeordnet ist. Weist das Bedienelement einen zweiten Sensor in einer zweiten Zone des Handschuhs auf, die einen zweiten Finger des Benutzers bedeckt, so gilt dies für den mindestens einen zweiten Sensor entsprechend.

Über das erfindungsgemäße Handbedienelement lassen sich eine Vielzahl von Steuerfunktionen für elektrisch steuerbare Vorrichtungen (z.B. eine Schaltfunktion und/oder eine Eingabefunktion) somit allein durch mindestens eine Fingerbewegung, optional mehrere Fingerbewegungen, realisieren. Das grundlegende Funktionsprinzip des erfindungsgemäßen Handbedienelements besteht somit in der Messung einer Veränderung des elektrischen Widerstands und/oder der elektrischen Kapazität über mindestens einen Sensor bei der Verformung von einem Finger oder der Handinnenseite, der/die von einer Zone des Handbedienelements bedeckt ist, in der sich der mindestens eine Sensor befindet.

Die Steuerfunktion des Handbedienelements ergibt sich also daraus, dass bei einer definierten mechanischen Betätigung von mindestens einem Sensor (bevorzugt mehreren Sensoren) ein elektrischer Widerstand und/oder eine elektrische Kapazität verändert wird und durch Bewegung von Teilen der Hand kontinuierlich verändert werden kann, um damit (über die eine elektronische Steuerungseinheit) ein Steuersignal für eine elektrisch steuerbare Vorrichtung zu erzeugen.

Der mindestens eine Sensor kann ein kapazitiver Sensor sein, der ausgewählt ist aus der Gruppe bestehend aus kapazitiver Näherungssensor, kapazitiver Schersensor und Kombinationen hiervon. Der mindestens eine Sensor kann ferner ein resistiver Sensor sein, der ausgewählt ist aus der Gruppe bestehend aus resistiver Näherungssensor, resistiver Schersensor und Kombinationen hiervon. Natürlich kann der mindestens eine Sensor auch beides sein, d.h. ein kapazitiver Sensor und ein resistiver Sensor oder das Handbedienelement einen kapazitiven Sensor oder einen resistiven Sensor enthalten. Der Vorteil von kapazitiven bzw. resistiven Sensoren gegenüber Dehnungssensoren liegt in ihrer höheren Empfindlichkeit, was eine empfindlichere Steuerung von elektrisch steuerbaren Vorrichtungen ermöglicht. Bevorzugt enthält das Handbedienelement mindestens einen (optional mehrere) Näherungssensoren. Auch bevorzugt enthält das Handbedienelement mindestens einen (optional mehrere) Schersensoren.

Bei einem erfindungsgemäßen kapazitiven oder resistiven Näherungssensor bzw. Schersensor befinden sich die zwei leitfähigen Elektrodenschichten, zwischen denen die Kapazität bzw. der Widerstand gemessen wird, auf verschiedenen Zonen des Handschuhs, z.B. auf unterschiedlichen Zonen des Handschuhs, die verschiedene Finger des Benutzers bedecken oder umschließen. Bei der Annäherung der beiden Finger bis zur Berührung und auch bei der anschließenden Druckausübung verändert sich die Kapazität bzw. der Widerstand in definierter Weise in Abhängigkeit vom Abstand. Im Fall eines eindimensionalen kapazitiven oder resistiven Schersensors befinden sich z.B. zwei Elektrodenschichten auf einem Finger des Handschuhs (= Zone des Handschuhs, welche diesen Finger des Benutzers bedeckt) und die dritte Elektrodenschicht auf einem anderen Finger des Handschuhs (= andere Zone des Handschuhs, welche den anderen Finger des Benutzers bedeckt). Bei der Scherbewegung des zweiten Fingers auf dem ersten Finger verändern sich die Kapazitäten bzw. die Widerstände zwischen den zwei Elektrodenschichten des ersten Fingers und der Elektrodenschicht des zweiten Fingers in definierter Weise in Abhängigkeit von der Position des zweiten Fingers auf dem ersten Finger.

In einer bevorzugten Ausgestaltungsform weist das erfindungsgemäße Handbedienelement mindestens zwei, drei, vier, fünf, sechs, sieben, acht, neun, zehn, elf, zwölf, dreizehn oder mindestens vierzehn Sensoren auf. Diese weiteren Sensoren können die gleichen oder verschiedene strukturelle Merkmale wie der mindestens eine Sensor aufweisen.

Vorteilhafterweise sind die weiteren Sensoren jedoch in einer Zone des Handschuhs lokalisiert, die sich von der Zone unterscheidet, in welcher der mindestens eine (erste) Sensor lokalisiert ist (z.B. erster Sensor in einer Zone eines ersten Fingers und ein weiterer Sensor in einer Zone eines weiteren Fingers). In einer besonders bevorzugten Ausgestaltungsform enthält das Handbedienelement mindestens einen Sensor oder einen Teil eines Sensors in je einer Zone des Handschuhs, die einen der fünf Finger der menschlichen Hand mindestens teilweise bedeckt und optional mindestens einen Sensor oder einen Teil eines Sensors in einer Zone des Handschuhs, die die Handinnenseite mindestens teilweise bedeckt. Entsprechend kann somit das erfindungsgemäße Handbedienelement in sechs verschiedene Handzonen unterteilt werden. Ein Handbedienelement mit Sensoren an möglichst vielen unterschiedlichen Zonen hat den Vorteil, dass ein Benutzer des Handbedienelements einen größeren Freiraum bei der Betätigung der jeweiligen Sensoren hat und somit die elektrisch steuerbare Vorrichtung ein sehr breites Spektrum an Steuersignalen empfindlich und feinfühlig steuern kann.

Das erfindungsgemäße Handbedienelement kann ferner einen weiteren Sensor aufweisen, der nicht an der Generierung eines Steuersignals für die elektrisch steuerbare Vorrichtung beteiligt ist. Bevorzugt wird eine über diesen weiteren Sensor detektierte elektrische Kapazität und/oder ein über diesen weiteren Sensor detektierter elektrischer Widerstand von der elektronischen Steuerungseinheit des Handschuhs in mindestens ein Steuersignal zur Steuerung des Handschuhs selbst umgewandelt (z.B. ein Signal zur Aktivierung oder Deaktivierung des Handschuhs, d.h. ein Ein-Aus-Schalter des Handschuhs).

Das erfindungsgemäße Handbedienelement weist eine erste Zone und eine zweite Zone auf, wobei die erste und zweite Zone jeweils zur zumindest teilweisen Bedeckung eines Fingers oder einer Handinnenfläche eines Benutzers geeignet sind. Erfindungsgemäß sind die erste Zone und die zweite Zone an unterschiedlichen Stellen des Handbedienelements angeordnet (d.h. die erste Zone an einem Finger und die zweite Zone an einem anderen Finger oder an der Handinnenseite). Erfindungsgemäß sind die zwei Zonen für die Herstellung eines Steuersignals nötig, d.h. der mindestens eine Sensor benötigt die zwei Zonen zur Steuerung. Der mindestens eine Sensor ist erfindungsgemäß teilweise in der ersten Zone und teilweise in der zweiten Zone angeordnet.

Die erste Zone des Handbedienelements ist erfindungsgemäß zur zumindest teilweisen Bedeckung einer Fläche eines ersten Fingers eines Benutzers geeignet, bevorzugt einer Fläche eines Daumens eines Benutzers. Die zweite Zone des Handbedienelements ist erfindungsgemäß zur zumindest teilweisen Bedeckung einer Fläche eines zweiten Fingers derselben Hand eines Benutzers geeignet oder zur zumindest teilweisen Bedeckung der Handinnenfläche derselben Hand eines Benutzers geeignet. Die Fläche des ersten Fingers und/oder des zweiten Fingers kann insbesondere in Richtung der Handinnenfläche des Benutzers ausgerichtet sein und/oder in Richtung eines Nachbarfingers des Benutzers ausgerichtet sein.

Erfindungsgemäß ist die zweite Elektrodenschicht, und optional die Dielektrikumschicht, in einer Zone des tragbaren Handbedienelements angeordnet, die verschieden ist zu einer Zone des tragbaren Handbedienelements, in welcher die erste Elektrodenschicht angeordnet ist, wobei die zweite Elektrodenschicht erfindungsgemäß dazu geeignet ist, durch eine Bewegung des Handbedienelements über die erste Elektrodenschicht angeordnet zu werden, im Falle eines Sensors, der zur Messung von elektrischen Kapazitäten geeignet ist, dergestalt, dass die Dielektrikumschicht zwischen der ersten und zweiten Elektrodenschicht angeordnet ist. Diese Anordnung der Schichten kann sich auf eine Ausgestaltung des Sensors als Näherungssensor beziehen. Die Zonen sind hierbei insbesondere zur zumindest teilweisen Bedeckung eines Fingers oder einer Handinnenfläche eines Benutzers geeignet.

Für den Fall, dass der Sensor ein kapazitiver Schersensor oder ein resistiver Schersensor ist, weist der Sensor des Handbedienelements erfindungsgemäß eine dritte elektrisch leitfähige Elektrodenschicht auf, die in einer Zone des tragbaren Handbedienelements angeordnet ist, die zur zumindest teilweisen Bedeckung eines Fingers oder einer Handinnenfläche eines Benutzers geeignet ist, besonders bevorzugt in einer Zone des tragbaren Handbedienelements, die zur zumindest teilweisen Bedeckung eines Daumens eines Benutzers geeignet ist. Erfindungsgemäß ist diese Zone
i) identisch mit einer Zone des tragbaren Handbedienelements, in welcher die erste Elektrodenschicht angeordnet ist, wobei die dritte Elektrodenschicht bevorzugt neben der ersten Elektrodenschicht angeordnet ist und optional die Dielektrikumschicht auf der ersten und dritten Elektrodenschicht oder auf der zweiten Elektrodenschicht angeordnet ist; oder
ii) identisch mit einer Zone des tragbaren Handbedienelements, in welcher die zweite Elektrodenschicht angeordnet ist, wobei die dritte Elektrodenschicht bevorzugt neben der zweiten Elektrodenschicht angeordnet ist und optional die Dielektrikumschicht auf der zweiten und dritten Elektrodenschicht oder auf der ersten Elektrodenschicht angeordnet ist.

Diese Anordnung der Schichten betrifft eine Ausgestaltung des Sensors als Schersensor.

In einer bevorzugten Ausgestaltungsform weist der mindestens eine Sensor eine vierte, optional noch weitere, elektrisch leitfähige Elektrodenschicht(en) auf, die bevorzugt neben der ersten und/oder dritten Elektrodenschicht angeordnet sind. Diese Anordnung der Schichten bezieht sich insbesondere auf eine Ausgestaltung des Sensors als Schersensor.

In einer weiteren bevorzugten Ausgestaltungsform weist der mindestens eine Sensor eine weitere Dielektrikumsschicht, optional mehrere weitere Dielektrikumsschichten, auf. Die weitere(n) Dielektrikumschicht(en) kann/können die gleichen Eigenschaften wie die (erste) Dielektrikumschicht aufweisen.

Der Sensor kann ferner eine elektrische Abschirmschicht enthalten, die auf dem mindestens einen Sensor in Richtung einer Fläche einer Hand eines Benutzers angeordnet ist, wobei die Abschirmschicht bevorzugt eine elektrisch leitfähige Elektrodenschicht und eine Dielektrikumschicht enthält oder daraus besteht und die elektrisch leitfähige Elektrodenschicht in Richtung einer Fläche einer Hand eines Benutzers angeordnet ist.

Die erste und/oder zweite elektrisch leitfähige Elektrodenschicht, optional weitere Elektrodenschichten des mindestens einen Sensors, können eine profilierte Oberfläche aufweisen oder mindestens einen Hohlraum zwischen der ersten und zweiten Elektrodenschicht, und optional in der Dielekrikumschicht, aufweisen. Der Hohlraum kann Bestandteil eines geschäumten Materials sein.

Das Handbedienelement kann ein elektrisch nicht-leitfähiges Material enthalten, bevorzugt ein elektrisch nicht-leitfähiges Material ausgewählt aus der Gruppe bestehend aus Textil, Leder, Kunstleder, Kunststoff und Kombinationen hiervon, besonders bevorzugt einen Kunststoff, ganz besonders bevorzugt einen elastomeren Kunststoff. Hierbei kann der elastomere Kunststoff ausgewählt sein aus der Gruppe bestehend aus
i) Silikon, Fluorsilicon, Polyurethan, Polynorbornen, Kautschuk, Naturkautschuk, Fluorkautschuk, Styrol-Butadien, Isobutylen-Isopren, Ethylen-Propylen-Dien-Terpolymer, Poly-Chlorbutadien, chlorsulfoniertes Polyethylen, Acrylnitril-Butadien, hydriertes Acrylnitril-Butadien und Kombinationen hiervon;
ii) thermoplastische Styrol-Copolymere, besonders bevorzugt ausgewählt aus der Gruppe bestehend aus Styrol-Butadien-Styrol-Copolymer, Styrol-Ethylen-Butadien-Styrol-Copolymer, Styrol-Ethylen-Propylen-Styrol-Copolymer, Styrol-Ethylen-Ethylen-Propylen-Styrol-Copolymer, Styrol-Isopren-Styrol-Copolymer und Kombinationen hiervon;
iii) teilvernetzte Mischungen auf Polyolefin-Basis, bevorzugt ausgewählt aus der Gruppe bestehend aus Ethylen-Propylen-Dien-Kautschuk und Polypropylen, Nitril-Butadien-Kautschuk und Polypropylen, Ethylen-Propylen-Dien-Kautschuk und Polyethylen und Kombinationen hiervon;
iv) thermoplastische Urethan-Copolymere, bevorzugt ausgewählt aus der Gruppe bestehend aus TPU-ARES, TPUARET, TPU-AREE und Kombinationen hiervon; und
v) Kombinationen hiervon.

Die erste elektrisch leitfähige Elektrodenschicht, die zweite elektrisch leitfähige Elektrodenschicht und/oder die Dielektrikumschicht, optional weitere Elektrodenschichten und/oder Dielektrikumschichten des mindestens einen Sensors, können ein elektrisch nicht-leitfähiges Material enthalten, bevorzugt einen Kunststoff, besonders bevorzugt einen elastomeren Kunststoff. Hierbei kann der elastomere Kunststoff ausgewählt sein aus der Gruppe bestehend aus
i) Silikon und seine Derivate, Polyurethan, Polynorbornen, Kautschuk, Naturkautschuk, Fluorkautschuk, Styrol-Butadien, Isobutylen-Isopren, Ethylen-Propylen-Dien-Terpolymer, Poly-Chlorbutadien, chlorsulfoniertes Polyethylen, Acrylnitril-Butadien, hydriertes Acrylnitril-Butadien und Kombinationen hiervon, bevorzugt Silikon und seine Derivate;
ii) thermoplastische Styrol-Copolymere, besonders bevorzugt ausgewählt aus der Gruppe bestehend aus Styrol-Butadien-Styrol-Copolymer, Styrol-Ethylen-Butadien-Styrol-Copolymer, Styrol-Ethylen-Propylen-Styrol-Copolymer, Styrol-Ethylen-Ethylen-Propylen-Styrol-Copolymer, Styrol-Isopren-Styrol-Copolymer und Kombinationen hiervon;
iii) teilvernetzte Mischungen auf Polyolefin-Basis, bevorzugt ausgewählt aus der Gruppe bestehend aus Ethylen-Propylen-Dien-Kautschuk und Polypropylen, Nitril-Butadien-Kautschuk und Polypropylen, Ethylen-Propylen-Dien-Kautschuk und Polyethylen und Kombinationen hiervon;
iv) thermoplastische Urethan-Copolymere, bevorzugt ausgewählt aus der Gruppe bestehend aus TPU-ARES, TPUARET, TPU-AREE und Kombinationen hiervon; und
v) Kombinationen hiervon.

Die erste elektrisch leitfähige Elektrodenschicht und/oder die zweite elektrisch leitfähige Elektrodenschicht, optional weitere Elektrodenschichten des mindestens einen Sensors, kann/können ein elektrisch leitfähiges Material enthalten, bevorzugt ein Material ausgewählt aus der Gruppe bestehend aus Kohlenstoff, Metall, Halbmetall, elektrisch leitfähiger Kunststoff und Mischungen hiervon, besonders bevorzugt ein Material ausgewählt aus der Gruppe bestehend aus Ruß, Graphit, Graphen, Kohlenstoffnanoröhrchen, Eisen, Kupfer, Silber, Gold, Polyanilin, Polyacetylen, Polypyrrol, Polyparaphenylen, Polythiophen und Kombinationen hiervon. Ganz besonders bevorzugt liegt das Material in einer anisotropen Form vor, insbesondere in einer Form ausgewählt aus der Gruppe bestehend aus Partikeln, Plättchen, Stäbchen, Fasern und Kombinationen hiervon. Die Partikel können auch aus einem leitfähigen oder nicht leitfähigen Kern und einer leitfähigen Schale bestehen.

Die Dielektrikumschicht kann ein elektrisch polarisierbares Material enthalten, bevorzugt ein Material ausgewählt aus der Gruppe bestehend aus Bariumtitanat, Bleizirkonattitanat, Titandioxid und Mischungen hiervon, wobei das Material ganz besonders bevorzugt in einer anisotropen Form vorliegt, insbesondere in einer Form ausgewählt aus der Gruppe bestehend aus Partikeln, Plättchen, Stäbchen, Fasern und Kombinationen hiervon.

Die elektronische Steuerungseinheit des Handbedienelements kann dazu konfiguriert sein, eine vom Sensor detektierte elektrische Kapazität und/oder einen vom Sensor detektierten elektrischen Widerstand in eine stufenlose Steuergröße zur stufenlosen Steuerung einer elektrisch steuerbaren Vorrichtung umzuwandeln. Bei der stufenlosen Steuerung wird der mindestens eine Sensor des Handbedienelements dazu genutzt, um ein Steuersignal für die elektrisch steuerbare Vorrichtung kontinuierlich bzw. stufenlos in einer oder auch in mehreren Dimensionen bis zur gewünschten Einstellung zu verändern.

Ferner kann die elektronische Steuerungseinheit des Handbedienelements dazu konfiguriert sein, eine gestufte Steuergröße zur gestuften Schaltung einer elektrisch steuerbaren Vorrichtung, bevorzugt eine binäre Steuergröße zur binären Schaltung einer elektrisch steuerbaren Vorrichtung, umzuwandeln, wobei die elektronische Steuerungseinheit bevorzugt dazu konfiguriert ist, die Umwandlung in die gestufte Steuergröße durch einen Vergleich mindestens eines vom Sensor detektierten Werts für die elektrische Kapazität und/oder den elektrischen Widerstand mit mindestens einem Schwellenwert vorzunehmen, insbesondere basierend auf einem Überschreiten oder Unterschreiten von einem Schwellenwert oder basierend auf einer Bestimmung, ob der mindestens eine vom Sensor detektierte Wert in einem Intervall zwischen zwei Schwellenwerten liegt. Ferner kann eine Umwandlung in die gestufte Steuergröße durch Berücksichtigung von einem oder mehreren vom Sensor detektierten Wert(en) für die elektrische Kapazität und/oder den elektrischen Widerstand in einer mathematischen Funktion vorgenommen werden.

Bei der gestuften Steuerung einer elektrisch steuerbaren Vorrichtung wird bei einer definierten mechanischen Betätigung des mindestens einen Sensors des Handbedienelements ein Steuersignal generiert, das nach der Übertragung an die elektrisch steuerbare Vorrichtung (über die Kommunikationsschnittstelle) einen Schaltvorgang in der elektrisch steuerbaren Vorrichtung auslöst. Bei dieser gestuften Schaltung hat der mindestens eine Sensor somit die Aufgabe, bestimmte Vorgänge in der elektrisch steuerbaren Vorrichtung zu aktivieren oder zu deaktivieren. Es handelt sich hierbei beispielsweise eine binäre Entscheidung von JA oder NEIN (z.B. Anschalten von Bauteil oder Ausschalten von Bauteil).

In einer ganz bevorzugten Ausgestaltungsform ist die elektronische Steuerungseinheit dazu konfiguriert, eine vom Sensor detektierte elektrische Kapazität und/oder einen vom Sensor detektierten elektrischen Widerstand sowohl in eine stufenlose Steuergröße zur stufenlosen Steuerung einer elektrisch steuerbaren Vorrichtung und in eine gestufte Steuergröße zur gestuften Schaltung einer elektrisch steuerbaren Vorrichtung umzuwandeln.

Ferner kann die elektronische Steuerungseinheit des Handbedienelements dazu konfiguriert sein, ein Signal zu generieren, das eine Übernahme (d.h. eine Umsetzung und/oder Speicherung) einer stufenlosen oder gestuften Steuergröße auf Seiten der elektrischen Vorrichtung auslöst.

Die mindestens eine elektronische Steuerungseinheit des Handschuhs enthält vorzugsweise einen Mikroprozessor. Die mindestens eine elektronische Steuereinheit, die mindestens eine Kommunikationsschnittstelle und/oder die mindestens eine Energiequelle kann sich in einer Zone des Handbedienelements befinden, welche die Rückseite einer Hand eines Benutzers oder den angrenzenden Arm zumindest teilweise bedeckt oder zumindest teilweise umschließt.

Das Steuersignal, das von der elektronischen Steuerungseinheit erzeugt wird, kann mindestens eines der folgenden Signale umfassen:
- Befehl zur Aktivierung und/oder Deaktivierung von einzelnen Steuerelementen der elektrisch steuerbaren Vorrichtung (z.B. ein Schaltelement der elektrisch steuerbaren Vorrichtung);
- Information, die sich auch auf einer Tastatur finden (z.B. Schriftzeichen); und
- Befehl zu Bestätigung, dass das vom Handschuh übermittelte Steuersignal umgesetzt und/oder gespeichert werden soll.

Die Kommunikationsschnittstelle des Handbedienelements kann dazu konfiguriert sein, das Steuersignal der elektronischen Steuerungseinheit kabellos an eine elektrisch steuerbare Vorrichtung zu senden, bevorzugt über ein kabelloses Signal ausgewählt aus der Gruppe bestehend aus Bluetooth, WLAN, ZigBee, Z-Wave, Thread, 2G, 3G, 4G, 5G, LTE und Kombinationen hiervon.

Ferner werden ein Kit (d.h. eine Kombination) enthaltend ein erfindungsgemäßes Handbedienelement und eine elektrisch steuerbare Vorrichtung bereitgestellt, wobei die elektrisch steuerbare Vorrichtung dazu konfiguriert ist, mindestens ein Steuersignal der elektronischen Steuerungseinheit des tragbaren Handbedienelements zu empfangen und durch dieses gesteuert zu werden.

Die elektrisch steuerbare Vorrichtung kann ausgewählt sein aus der Gruppe bestehend aus Haushaltsgerät, Roboter, Straßenfahrzeug, Wasserfahrzeug, Flugobjekt, Computer, Eingabeschnittstelle für einen Computer (z.B. Joystick, Maus, Tastatur), Logistikfahrzeug, Produktionsmaschine, Förderband, Unterhaltungselektronikbauteil, Haustechnikbauteil, VR/AR-Brille und Kombinationen hiervon. Bevorzugt handelt es sich um eine VR/AR-Brille.

Es wird die Verwendung des erfindungsgemäßen Handbedienelements zur Steuerung von einer elektrisch steuerbaren Vorrichtung vorgeschlagen, wobei es sich bei der elektrisch steuerbaren Vorrichtung bevorzugt um
i) ein Haushaltsgerät handelt, bevorzugt ein Haushaltsgerät ausgewählt aus der Gruppe bestehend aus Waschmaschine, Küchengerät, Staubsauger, Rasenmäher und Kombinationen hiervon, enthält oder daraus besteht; und/oder
ii) einen Roboter handelt, bevorzugt einen Roboter im persönlichen Bereich oder einen Industrie-Roboter; und/oder
iii) ein Straßenfahrzeug oder Wasserfahrzeug handelt, wobei die Steuerung insbesondere ein Öffnen von Türen, Schließen von Türen, eine Beleuchtung, eine Spiegeleinstellung, eine Klimatisierung, eine Navigation und/oder eine Unterhaltungselektronik betrifft;; und/oder
iv) ein Flugobjekt handelt, bevorzugt eine Drohne; und/oder
v) einen Computer handelt, bevorzugt einen Computer ausgewählt aus der Gruppe bestehend aus PC, Notebook, Tablet, Smartphone und Kombinationen hiervon; und/oder
vi) eine Eingabeschnittstelle für einen Computer handelt, bevorzugt einen Joystick, eine Maus, eine Tastatur und Kombinationen hiervon; und/oder
vii) ein Logistikfahrzeug handelt; und/oder
viii) eine Produktionsmaschine handelt; und/oder
ix) ein Förderband handelt; und/oder
x) ein Unterhaltungselektronikbauteil handelt, bevorzugt ausgewählt aus der Gruppe bestehend aus Fernseher, Audioanlagen, Beamer, Kamera, MP3-Player, Lautsprecher, Kopfhörer, Spielekonsole und Kombinationen hiervon; und/oder
xi) ein Haustechnikbauteil handelt, bevorzugt ein Haustechnikbauteil ausgewählt aus der Gruppe bestehend aus Heizungsanlage, Klimaanlage, Sonnenschutzanlage und Kombinationen hiervon; und/oder
xii) eine VR/AR-Brille handelt, wobei die Steuerung insbesondere auf der VR/AR-Brille dargestellte elektronische Funktionen betrifft.

Die Verwendung ist erfindungsgemäß dergestalt, dass die Steuerung der elektrisch steuerbaren Vorrichtung durch ein Zusammenführen der zwei Zonen des tragbaren Handbedienelements erfolgt.

Anhand der nachfolgenden Figuren und Beispiele soll der erfindungsgemäße Gegenstand näher erläutert werden, ohne diesen auf die hier dargestellten, spezifischen Ausführungsformen einschränken zu wollen.

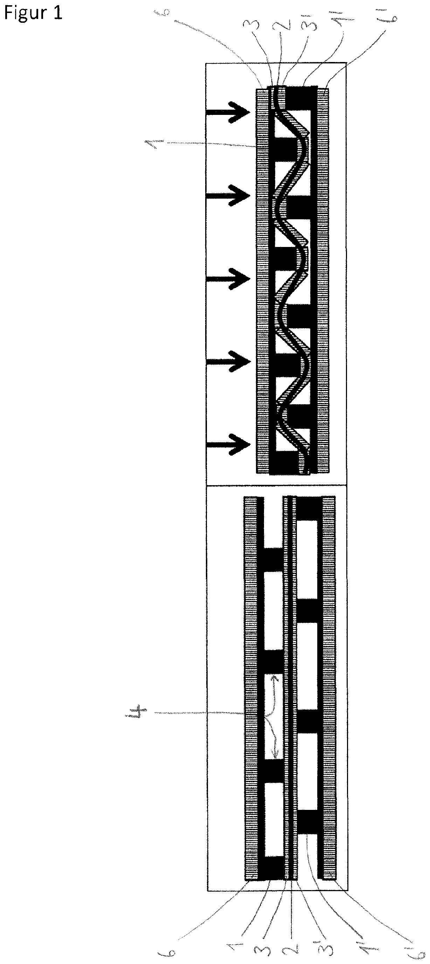

Die folgenden Figuren 1, 2, 9 und 10 und die folgenden Beispiele 1 und 4 sind nicht erfindungsgemäß und dienen lediglich der Veranschaulichung.

Figur 1 zeigt in Seitenansicht einen kapazitiven Drucksensor, bestehend aus zwei flächigen Elastomerfolien 6, 6' mit Noppenprofilen 4 und Elektrodenbeschichtungen aus leitfähigem Elastomer 1, 1' auf der Innenseite. Zwischen den Noppen 4 liegt eine dreischichtige flächige Elastomerfolie mit leitfähiger Innenschicht 2 und nicht leitfähigen Außenschichten 3, 3'. Die leitfähige Innenschicht 2 dient als Gegenelektrode zu den äußeren Elektrodenschichten 1, 1' auf den Noppenprofilen 4. Die linke Figur zeigt den Sensor im unbelasteten Zustand. In der rechten Figur ist der Sensor im komprimierten Zustand dargestellt. Beim Zusammendrücken nähern sich die Elektrodenschichten 1, 1' aneinander an, wodurch die Kapazität ansteigt. Solche Drucksensoren sind Stand der Technik.

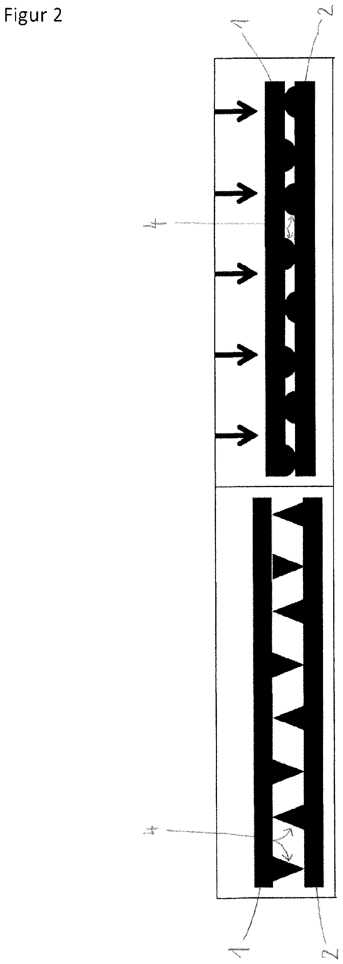

Figur 2 zeigt in Seitenansicht einen resistiven Drucksensor, bestehend aus zwei flächigen Elastomerfolien 1, 2 mit Noppenprofilen 4 aus leitfähigem Elastomer. Die linke Figur zeigt den Sensor im unbelasteten Zustand. In der rechten Figur ist der Sensor im komprimierten Zustand dargestellt. Beim Zusammendrücken verformen sich die leitfähigen Noppen 4. Durch die größere Kontaktfläche sinkt der Widerstand ab. Ein solches Messprinzip entspricht dem Stand der Technik.

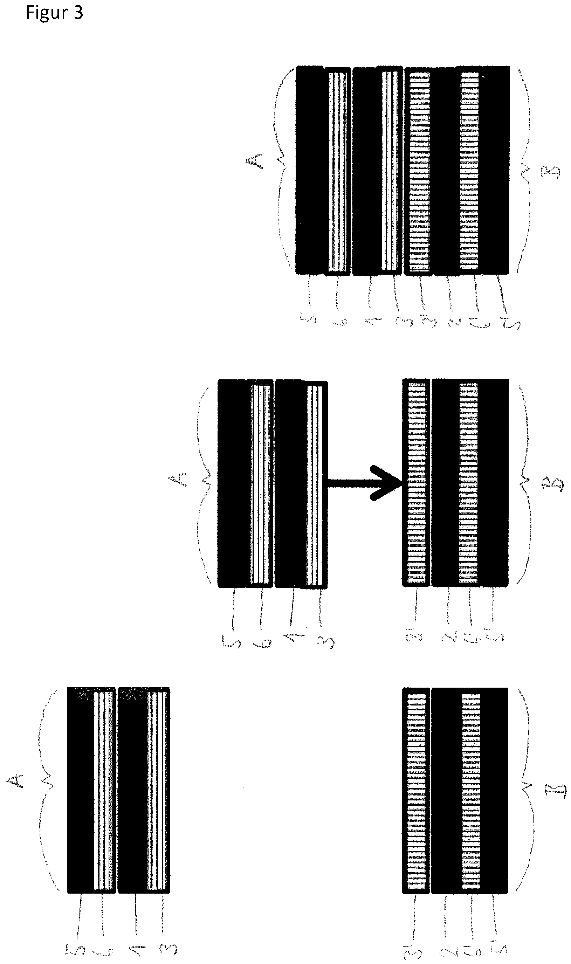

Figur 3 zeigt in Seitenansicht einen kapazitiven Näherungssensor, bestehend aus zwei zunächst in großem Abstand übereinander angeordneten vierschichtigen flächigen Komponenten A, B. Jede der beiden Komponenten A, B besteht aus einer leitfähigen Elastomerschicht 1, 2, die beidseitig mit einer nicht leitfähigen Elastomerschicht 3, 3', 6, 6' bedeckt ist. Auf der Außenseite kommt jeweils als vierte Schicht eine leitfähige Elastomerschicht 5, 5' zur elektrischen Abschirmung gegenüber der Hand hinzu. Die Kapazität wird zwischen den mittleren leitfähigen Schichten 1, 2 der beiden Komponenten des kapazitiven Näherungssensors gemessen. Sie erhöht sich bei der Annäherung der beiden Komponenten bis zur Berührung (in Figur 3 von links nach rechts).

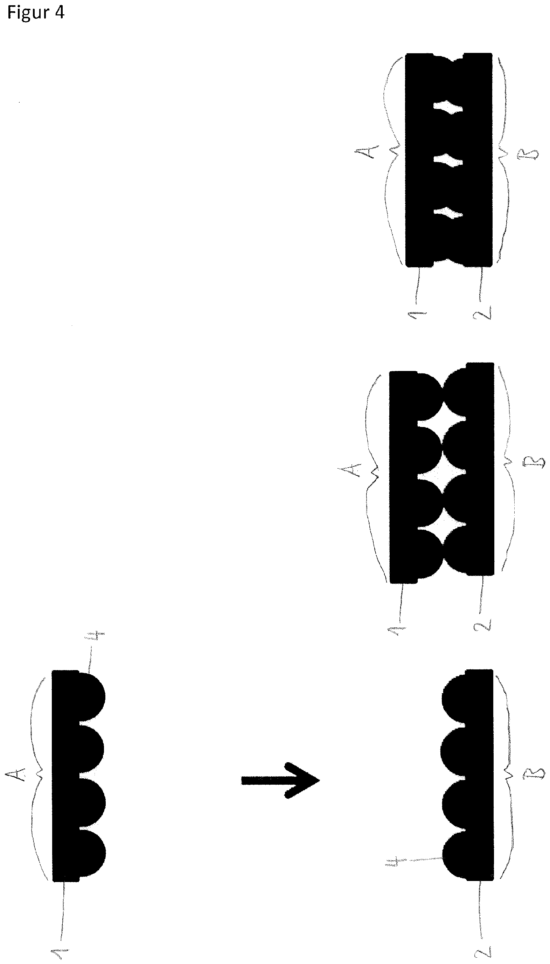

Figur 4 zeigt in Seitenansicht einen resistiven Näherungssensor, bestehend aus zwei flächigen Komponenten A, B, d.h. zwei zunächst in großem Abstand übereinander angeordneten auf der Innenseite mit Noppen 4 bedeckte flächige, leitfähigen Elastomerfolien 1, 2. Bei der Berührung und mit steigendem Andruck sinkt der elektrische Widerstand ab (in Figur 4 von links nach rechts).

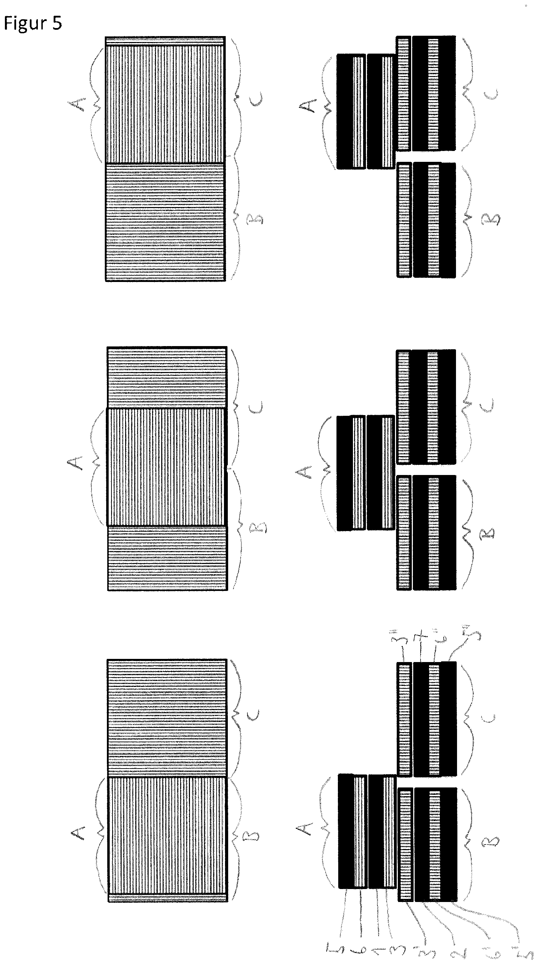

Figur 5 zeigt einen kapazitiven Schersensor von oben (oben) und in Seitenansicht (unten), bestehend aus zwei nebeneinander angeordneten vierschichtigen flächigen Komponenten B, C und einer dritten vierschichtigen flächigen Komponente A darüber. Jede der drei vierschichtigen flächigen Komponenten A, B, C besteht aus einer leitfähigen Elastomerschicht 1, 2, 7, die beidseitig mit einer nicht leitfähigen Elastomerschicht 3, 3^{I}, 3^{II}, 6, 6^{I}, 6" bedeckt ist. Auf der Außenseite kommt jeweils als vierte Schicht eine leitfähige Elastomerschicht 5, 5^{I}, 5" zur elektrischen Abschirmung gegenüber der Hand hinzu. Zwei Kapazitäten werden jeweils zwischen den mittleren leitfähigen Schichten 1, 2, 7 der beiden unteren Komponenten B, C und der oberen Komponente A des kapazitiven Schersensors gemessen. Anfangs ist die Kapazität zwischen der oberen A und der linken unteren Komponente B durch die hohe Überlappung groß und die Kapazität zwischen der oberen A und der rechten unteren Komponente C durch die geringe Überlappung klein. Durch die Scherbewegung der oberen Komponente A gegenüber den unteren Komponenten B, C kehrt sich das Verhältnis der Kapazitäten um (in Figur 5 von links nach rechts).

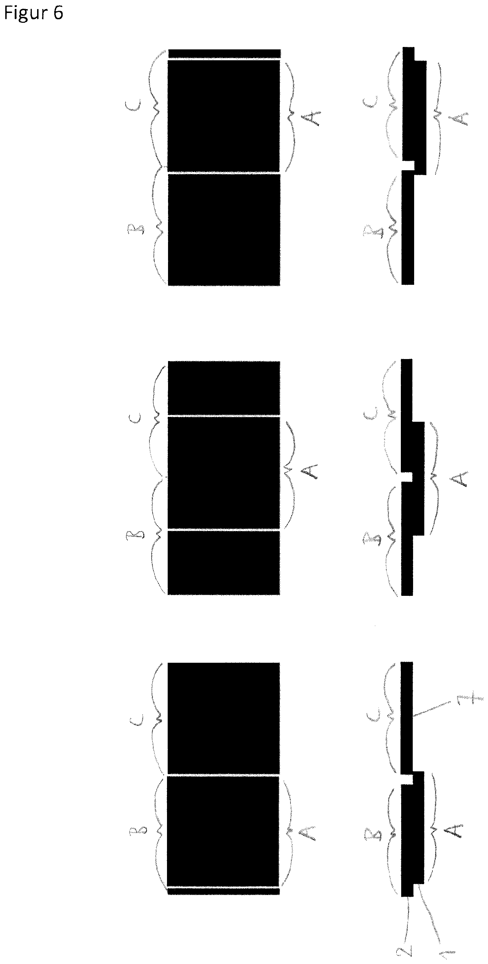

Figur 6 zeigt einen resistiven Schersensor von oben (oben) und in Seitenansicht (unten), bestehend aus zwei nebeneinander angeordneten flächigen leitfähigen Elastomerschichten 2, 7 und einer dritten flächigen leitfähigen Elastomerschicht 1 darunter. Zwei Widerstände werden jeweils zwischen den beiden oberen leitfähigen Elastomerschichten 2, 7 und der unteren leitfähigen Elastomerschicht 1 des resistiven Schersensors gemessen. Anfangs ist der Widerstand zwischen der unteren 1 und der linken oberen 2 leitfähigen Elastomerschicht durch die hohe Überlappung klein und der Widerstand zwischen der unteren 1 und der rechten oberen 7 leitfähigen Elastomerschicht durch die geringe Überlappung groß. Durch die Scherbewegung der unteren leitfähigen Elastomerschicht 1 gegenüber den oberen leitfähigen Elastomerschichten 2, 7 kehrt sich das Verhältnis um (in Figur 6 von links nach rechts).

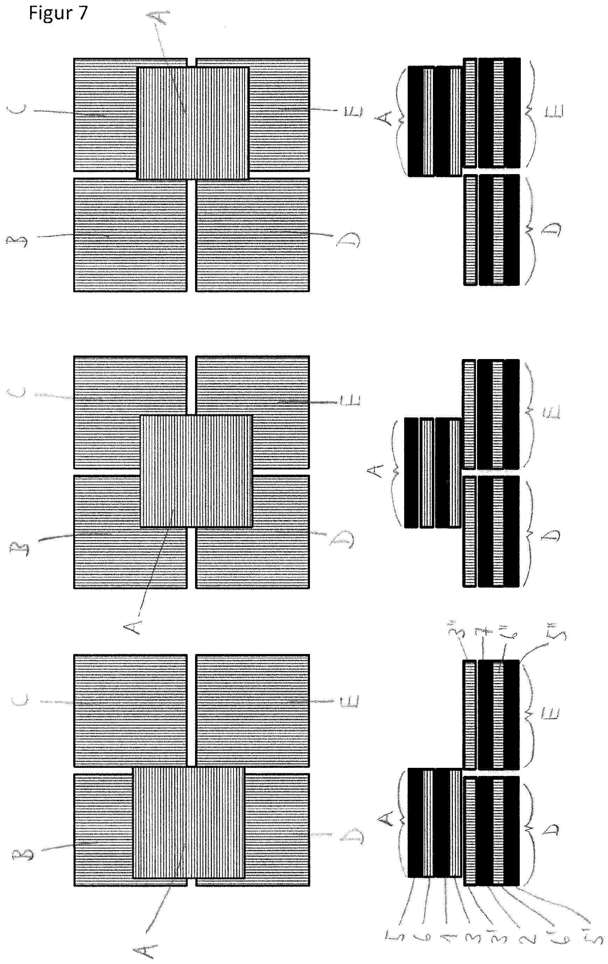

Figur 7 zeigt einen zweidimensionalen kapazitiven Schersensor von oben (oben) und in Seitenansicht (unten), bestehend aus vier in einem Viereck angeordneten vierschichtigen flächigen Komponenten B, C, D, E und einer fünften vierschichtigen flächigen Komponente A darüber. Jede der fünf vierschichtigen flächigen Komponenten A, B, C, D, E besteht aus einer leitfähigen Elastomerschicht 1, 2, 7, die beidseitig mit einer nicht leitfähigen Elastomerschicht 3, 3^{I}, 3", 6, 6^{I}, 6" bedeckt ist. Auf der Außenseite kommt jeweils als vierte Schicht eine leitfähige Elastomerschicht 5, 5^{I}, 5" zur elektrischen Abschirmung gegenüber der Hand hinzu. Vier Kapazitäten werden jeweils zwischen den mittleren leitfähigen Schichten 1, 2, 7 der vier unteren Komponenten B, C, D, E und der oberen Komponente A des zweidimensionalen kapazitiven Schersensors gemessen. Anfangs ist die Kapazität zwischen der oberen A und den beiden linken unteren Komponenten B, D durch die hohe Überlappung groß und die Kapazität zwischen der oberen A und den beiden rechten unteren Komponenten C, E durch die geringe Überlappung klein. Durch die Scherbewegung der oberen Komponente A gegenüber den unteren Komponenten B, C, D, E von links nach rechts kehrt sich das Verhältnis der Kapazitäten um (in Figur 7 von links nach rechts). Analog kann auch das Verhältnis der Kapazitäten zwischen der oberen Komponente A und den vorderen Komponenten D, E bzw. den hinteren Komponenten B, C durch eine Scherbewegung von vorn nach hinten verändert werden.

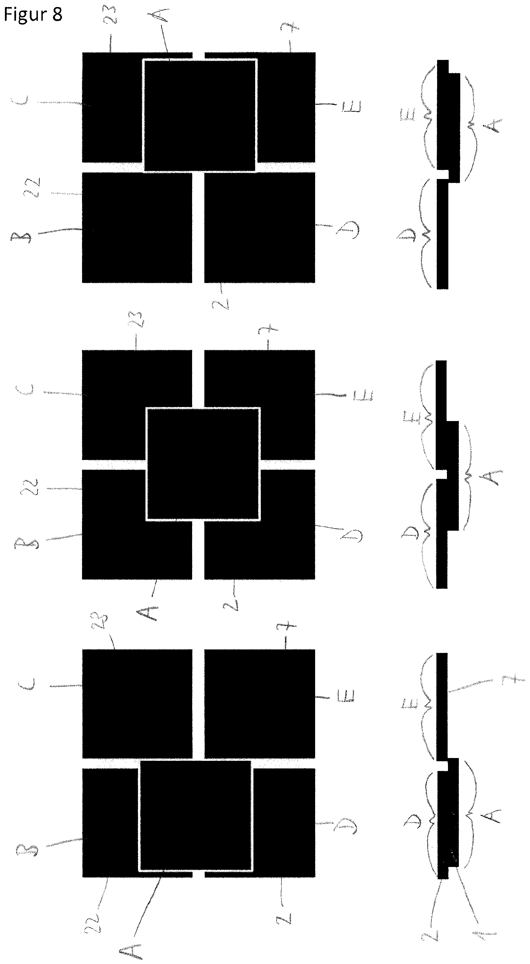

Figur 8 zeigt einen zweidimensionalen resitiven Schersensor von oben (oben) und in Seitenansicht (unten), bestehend aus vier in einem Viereck angeordneten flächigen leitfähigen Elastomerschichten 2, 2^{I}, 7, 7^{I} (Komponenten B, C, D, E) und einer fünften flächigen leitfähigen Elastomerschicht 1 (Komponente A) darunter. Vier Widerstände werden jeweils zwischen den vier oberen leitfähigen Elastomerschichten 2, 7 und der unteren leitfähigen Elastomerschicht 1 des zweidimensionalen resistiven Schersensors gemessen. Anfangs ist der Widerstand zwischen der unteren 1 und den beiden linken oberen 2, 2^{I} leitfähigen Elastomerschichten durch die hohe Überlappung klein und der Widerstand zwischen der unteren 1 und den beiden rechten oberen 7, 7^{I} leitfähigen Elastomerschichten durch die geringe Überlappung groß. Durch die Scherbewegung der unteren 1 leitfähigen Elastomerschicht gegenüber den oberen leitfähigen Elastomerschichten 2, 2^{I} von links nach rechts kehrt sich das Verhältnis der Widerstände um (in Figur 8 von links nach rechts). Analog kann auch das Verhältnis der Widerstände zwischen der unteren leitfähigen Elastomerschicht 1 und den vorderen leitfähigen Elastomerschichten 2, 7 bzw. den hinteren leitfähigen Elastomerschichten 2^{I}, durch eine Scherbewegung von vorn nach hinten verändert werden.

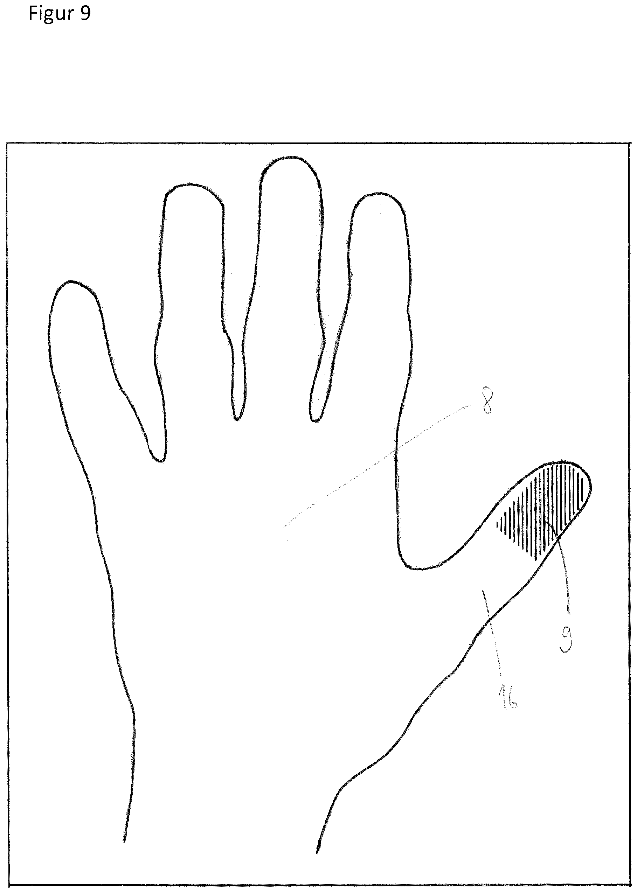

Figur 9 zeigt ein Handbedienelement als Handschuh mit einem kapazitiven Drucksensor 9 (s. Figur 1) auf der Innenseite des Daumens 16. Durch die Ausübung von Druck mit einem der anderen Finger auf den Drucksensor 9 ändert sich die messbare Kapazität in Abhängigkeit von der Druckstärke. Durch die Übertragung der gemessenen Kapazitätswerte auf eine technische Funktion wie beispielsweise die Helligkeit einer Lampe kann diese durch die geeignete Druckstärke zwischen Daumen 16 und anderem Finger auf den gewünschten Wert eingestellt werden.

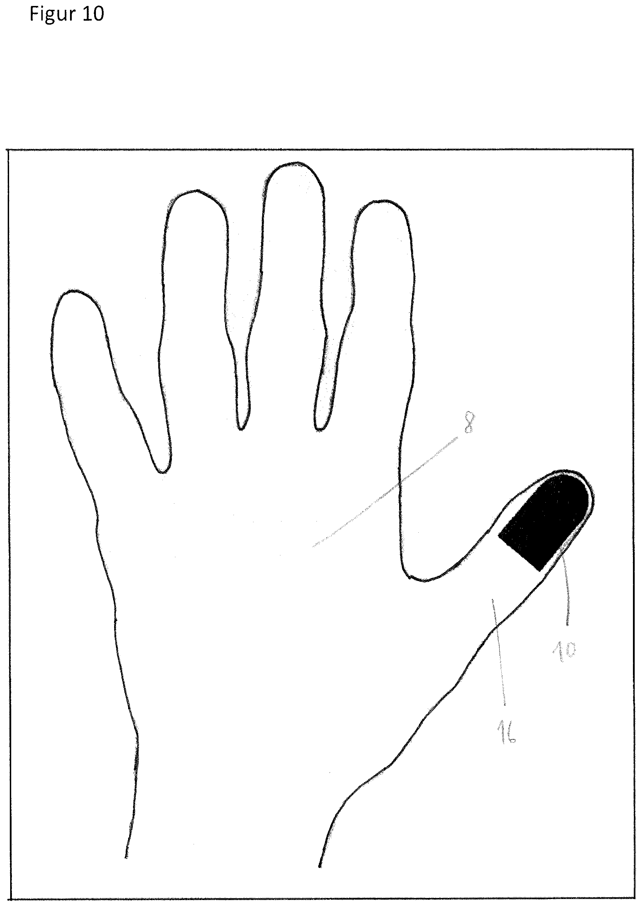

Figur 10 zeigt ein Handbedienelement als Handschuh mit einem resistiven Drucksensor 10 (s. Figur 2) auf der Innenseite des Daumens 16. Durch die Ausübung von Druck mit einem der anderen Finger auf den Drucksensor 10 ändert sich der messbare Widerstand in Abhängigkeit von der Druckstärke. Durch die Übertragung der gemessenen Widerstandwerte auf eine technische Funktion wie beispielsweise die Helligkeit einer Lampe kann diese durch die geeignete Druckstärke zwischen Daumen 16 und anderem Finger auf den gewünschten Wert eingestellt werden.

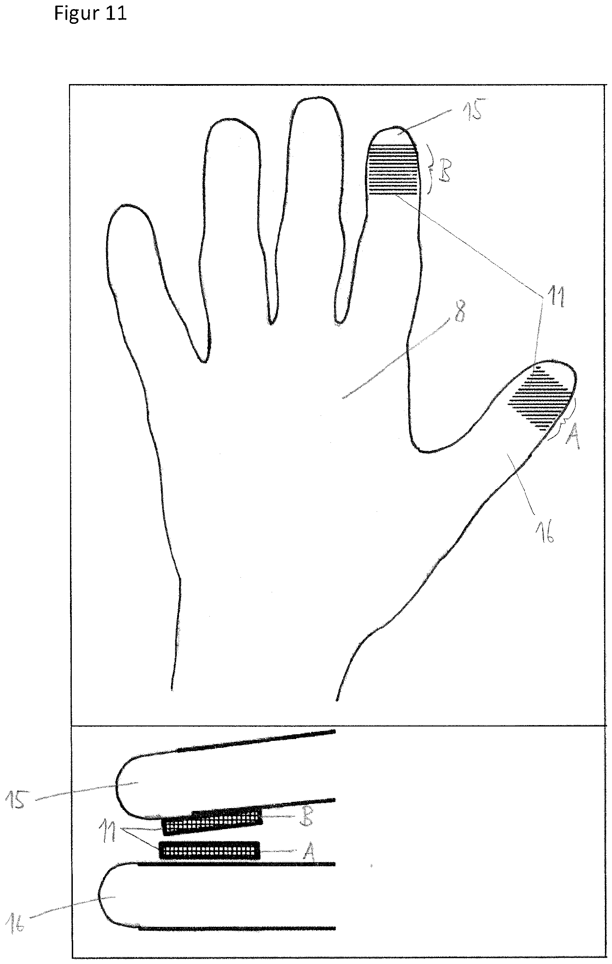

Figur 11 zeigt ein erfindungsgemäßes Handbedienelement als Handschuh mit einem kapazitiven Näherungssensor 11, dessen zwei Komponenten A, B (s. Figur 3) auf den Innenseiten des Daumens 16 und eines anderen Fingers 15 angebracht sind. Durch das Zusammenführen des Daumens 16 und des anderen Fingers 15 und die damit hervorgerufene Annäherung der beiden Komponenten A, B des kapazitiven Näherungssensors 11 ändert sich die messbare Kapazität in Abhängigkeit vom Abstand der beiden Komponenten A, B des kapazitiven Näherungssensors 11. Beim Überschreiten eines Schwellwertes der Kapazität kann ein Schaltvorgang ausgelöst werden. Dieser Schaltvorgang ist beispielsweise die Aktivierung oder Deaktivierung von Bedienfunktionen am Handschuh.

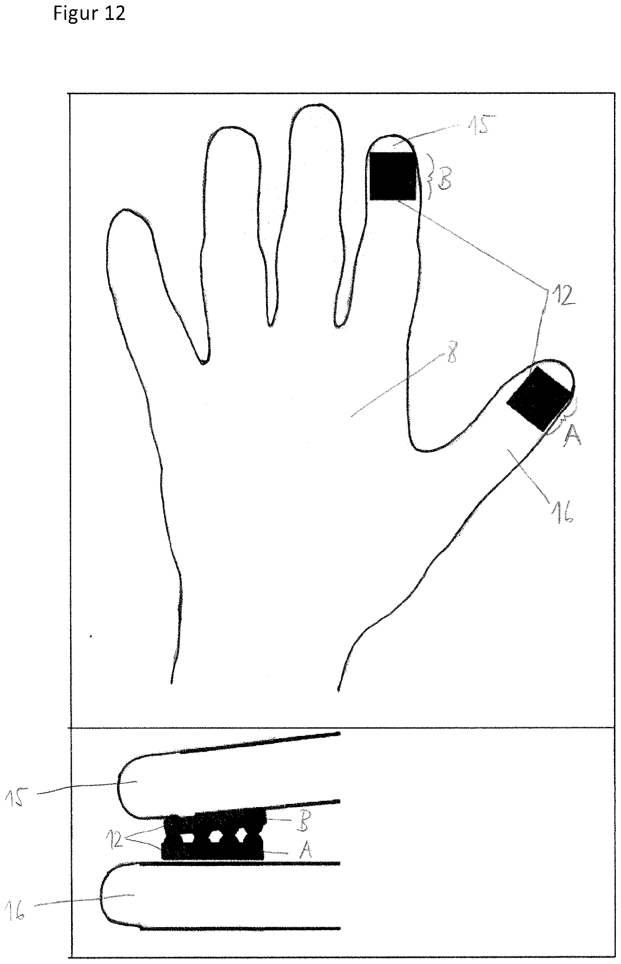

Figur 12 zeigt ein erfindungsgemäßes Handbedienelement als Handschuh mit einem resistiven Näherungssensor 12, dessen zwei Komponenten A, B (s. Figur 4) auf den Innenseiten des Daumens 16 und eines anderen Fingers 15 angebracht sind. Durch das Zusammenführen des Daumens 16 und des anderen Fingers 15 und die damit hervorgerufene Berührung der beiden Komponenten A, B des resistiven Näherungssensors 12 ändert sich der messbare Widerstand in Abhängigkeit vom Andruck der beiden Komponenten A, B des resistiven Näherungssensors 12. Beim Überschreiten eines Schwellwertes des Widerstandes kann ein Schaltvorgang ausgelöst werden. Dieser Schaltvorgang ist beispielsweise die Aktivierung oder Deaktivierung von Bedienfunktionen am Handschuh.

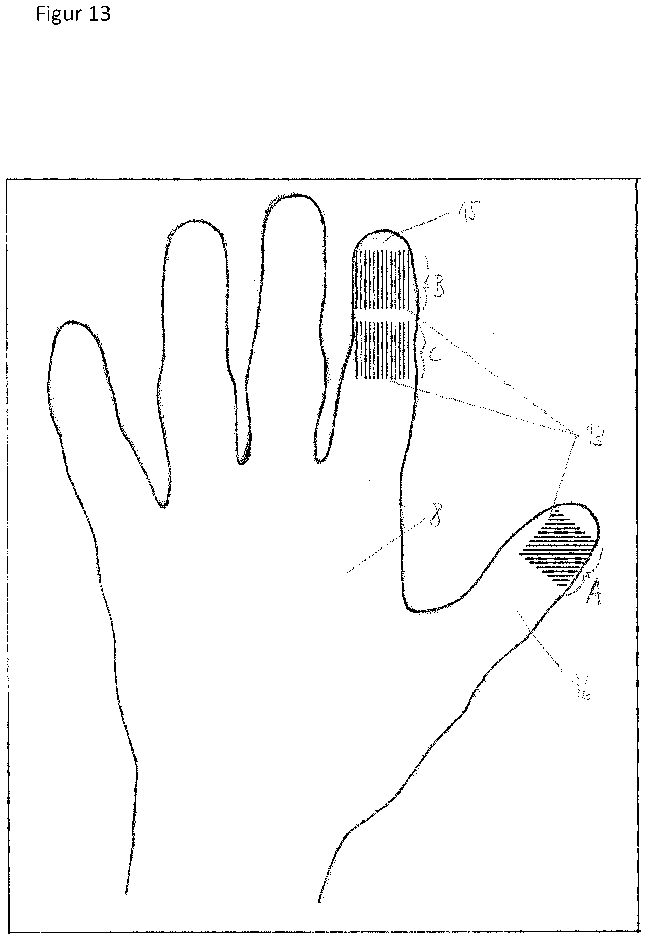

Figur 13 zeigt ein erfindungsgemäßes Handbedienelement als Handschuh mit einem kapazitiven Schersensor 13, dessen drei Komponenten A, B, C (s. Figur 5) auf den Innenseiten des Daumens 16 und des Zeigefingers 15 angebracht sind. Durch eine Scherbewegung des Daumens 16 entlang des Zeigefingers 15 und die damit sich verändernde Überlappung der Komponente A des kapazitiven Näherungssensors 13 am Daumen 16 mit den zwei Komponenten B, C am Zeigefinger 15 wird die eine Kapazität kleiner und die andere Kapazität größer, d. h. das Verhältnis der zwei messbaren Kapazitäten ändert sich in Abhängigkeit von der Position des Daumens 16 auf dem Zeigefinger 15. Damit kann eine technische Funktion wie beispielsweise die Helligkeit einer Lampe durch die Position des Daumens 16 auf dem Zeigefinger 15 auf den gewünschten Wert eingestellt werden.

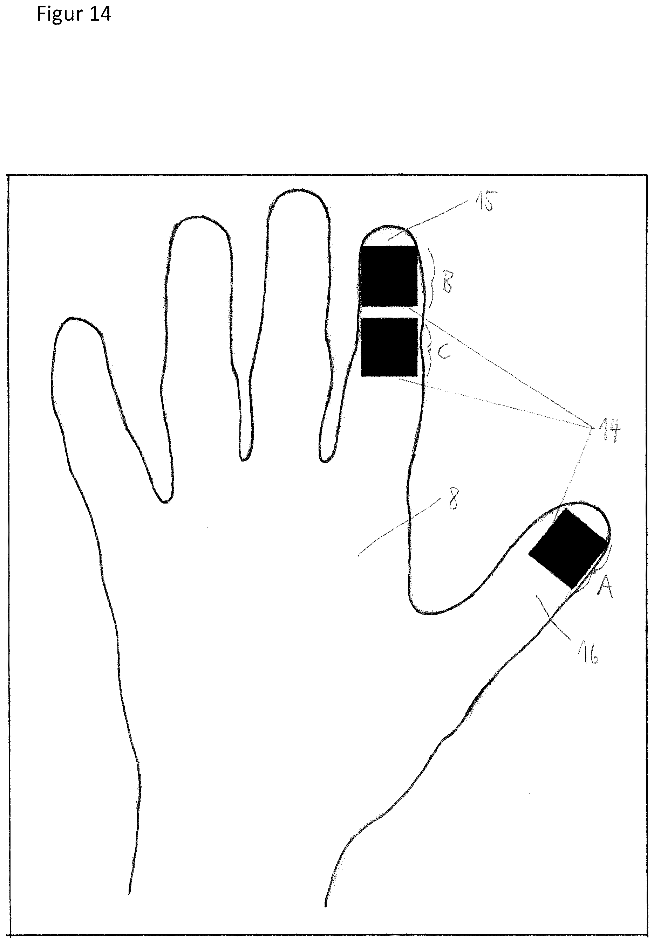

Figur 14 zeigt ein erfindungsgemäßes Handbedienelement als Handschuh mit einem resistiven Schersensor 14, dessen drei Komponenten A, B, C (s. Figur 6) auf den Innenseiten des Daumens 16 und des Zeigefingers 15 angebracht sind. Durch eine Scherbewegung des Daumens 16 entlang des Zeigefingers 15 und die damit sich verändernde Überlappung der Komponente A des resistiven Näherungssensors 14 am Daumen 16 mit den zwei Komponenten B, C am Zeigefinger wird der eine Widerstand kleiner und der andere Widerstand größer, d. h. das Verhältnis der zwei messbaren Widerstände ändert sich in Abhängigkeit von der Position des Daumens 16 auf dem Zeigefinger 15. Damit kann eine technische Funktion wie beispielsweise die Helligkeit einer Lampe durch die Position des Daumens 16 auf dem Zeigefinger 15 auf den gewünschten Wert eingestellt werden.

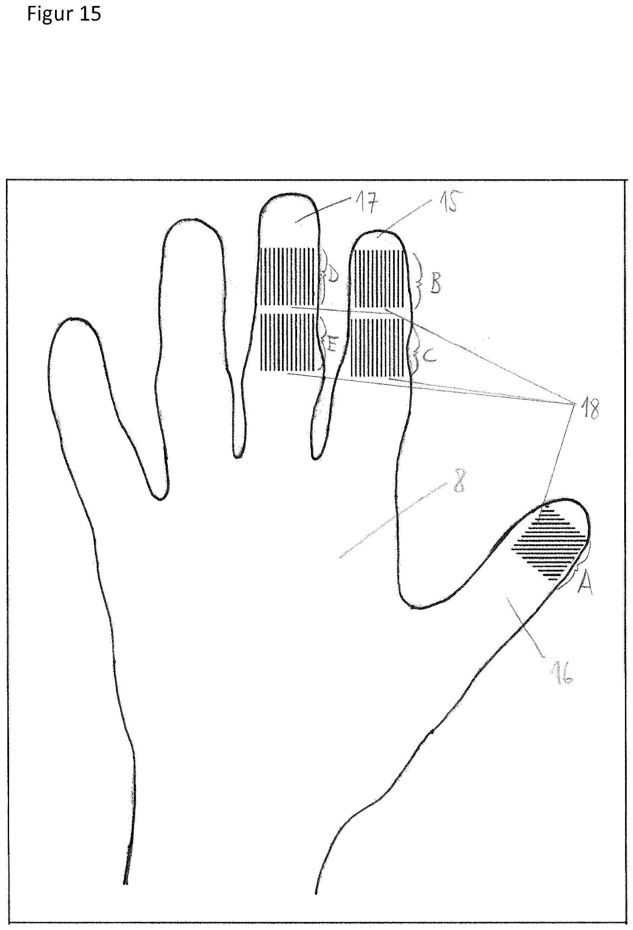

Figur 15 zeigt ein erfindungsgemäßes Handbedienelement als Handschuh mit einem zweidimensionalen kapazitiven Schersensor 18, dessen fünf Komponenten A, B, C, D, E (s. Figur 7) auf den Innenseiten des Daumens 16, des Zeigefingers 15 und des Mittelfingers 17 angebracht sind. Durch eine Scherbewegung des Daumens 16 entlang von und zwischen Zeigefinger 15 und Mittelfinger 17 und die damit sich verändernde Überlappung der Komponente A des kapazitiven Näherungssensors 18 am Daumen 16 mit den vier Komponenten B, C, D, E an Zeigefinger 15 und Mittelfinger 17 werden manche Kapazitäten kleiner und andere größer, d. h. die Verhältnisse der messbaren Kapazitäten ändern sich in Abhängigkeit von der Position des Daumens 16 auf dem Zeigefinger 15 und Mittelfinger 17. Damit kann eine zweidimensionale technische Funktion wie beispielsweise die Ausrichtung einer Lampe oder eines Spiegels durch die Position des Daumens 16 auf dem Zeigefinger 15 und Mittelfinger 17 wie gewünscht eingestellt werden.

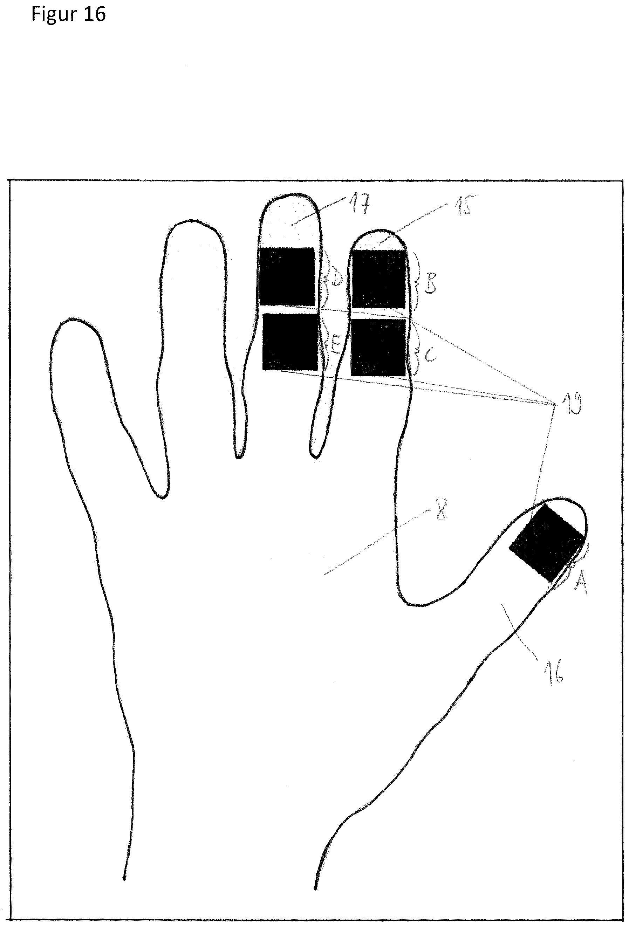

Figur 16 zeigt ein erfindungsgemäßes Handbedienelement als Handschuh mit einem zweidimensionalen resistiven Schersensor 19, dessen fünf Komponenten A, B, C, D, E (s. Figur 8) auf den Innenseiten des Daumens 16, des Zeigefingers 15 und des Mittelfingers 17 angebracht sind. Durch eine Scherbewegung des Daumens 16 entlang von und zwischen Zeigefinger 15 und Mittelfinger 17 und die damit sich verändernde Überlappung der Komponente A des resistiven Näherungssensors 19 am Daumen 16 mit den vier Komponenten B, C, D, E an Zeigefinger 15 und Mittelfinger 17 werden manche Widerstande kleiner und andere größer, d.h. die Verhältnisse der messbaren Widerstände ändern sich in Abhängigkeit von der Position des Daumens 16 auf dem Zeigefinger 15 und Mittelfinger 17. Damit kann eine zweidimensionale technische Funktion wie beispielsweise die Ausrichtung einer Lampe oder eines Spiegels durch die Position des Daumens 16 auf dem Zeigefinger 15 und Mittelfinger 17 wie gewünscht eingestellt werden.

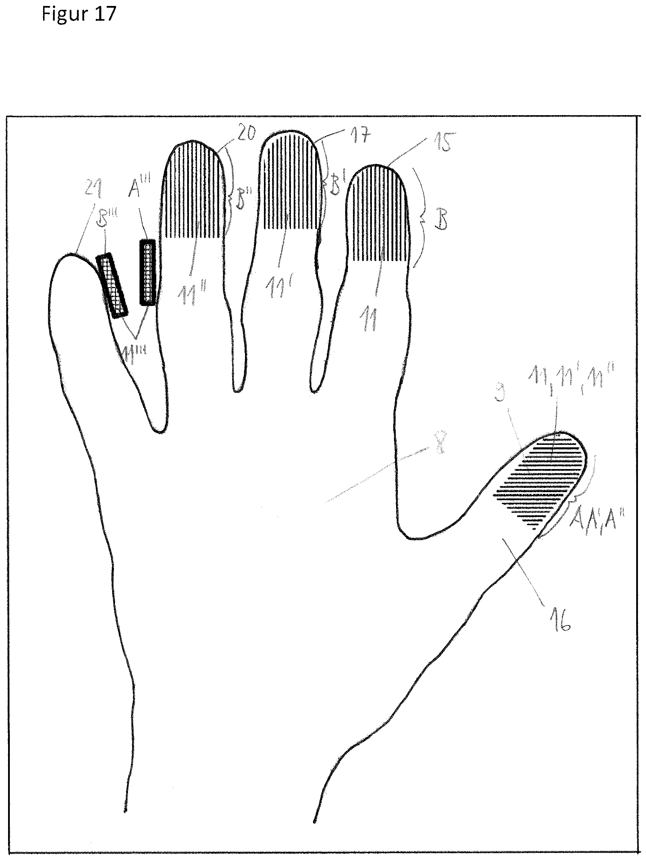

Figur 17 zeigt ein erfindungsgemäßes Handbedienelement als Handschuh mit einem kapazitiven Drucksensor 9 auf der Daumen-Innenseite, drei kapazitiven Näherungssensoren 11, 11^{I}, 11", deren gemeinsame eine Komponente A, A^{I}, A^{II} auf der Innenseite des Daumens 16 und deren anderen Komponenten B, B^{I}, B^{II} auf den Innenseiten von Zeige-, Mittel- und Ringfinger 15, 17, 20 angebracht sind. Ein vierter kapazitiver Näherungssensor 11^{III} befindet sich zwischen Ringfinger 20 und kleinem Finger 21 mit jeweils einer Komponente A^{III}, B^{III} an beiden Fingern. Bei der Annäherung des Daumens 16 an den Zeige-, Mittel- oder Ringfinger 15, 17, 20 wird der betreffende Finger durch den betreffenden kapazitiven Näherungssensor 11, 11^{I}, 11" identifiziert, sodass bei der anschließenden Ausübung von Druck auf den Daumen 16 drei verschiedene technische Funktionen gesteuert werden können. So lassen sich z.B. mit den drei Fingern die Helligkeiten von drei Lampen mit verschiedenen Farben individuell einstellen. Durch den vierten kapazitiven Näherungssensor 11^{III} zwischen Ringfinger 20 und kleinem Finger 21 kann der jeweils eingestellte Helligkeitswert über die Schaltfunktion übernommen und gespeichert werden.

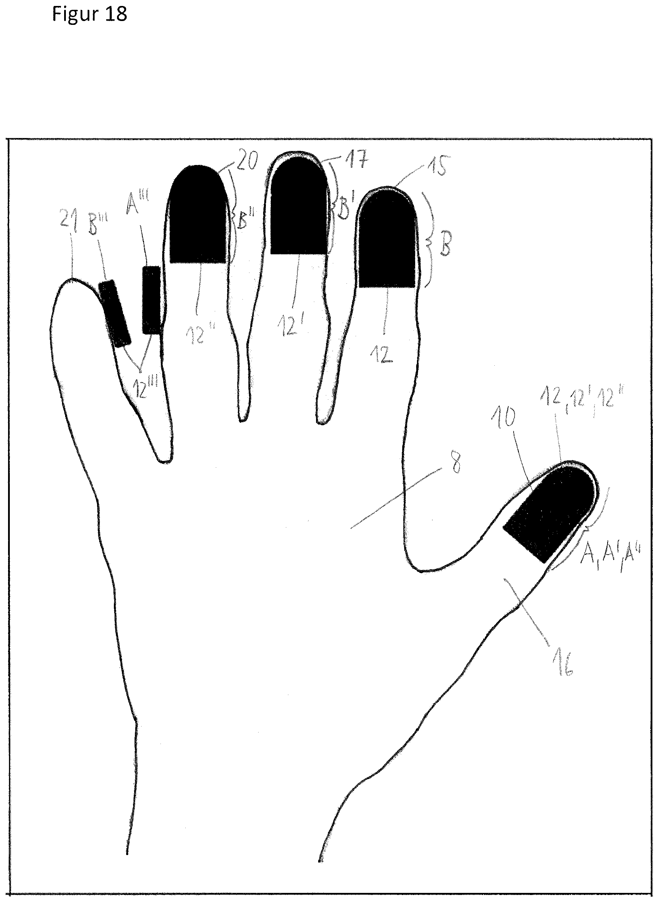

Figur 18 zeigt ein erfindungsgemäßes Handbedienelement als Handschuh mit einem resistiven Drucksensor auf der Daumen-Innenseite 10 und drei resistiven Näherungssensoren 12, 12^{I}, 12", deren gemeinsame eine Komponente A, A^{I}, A^{II} auf der Daumen-Innenseite und deren anderen Komponenten B, B^{I}, B^{II} auf den Innenseiten von Zeige-, Mittel- und Ringfinger 15, 17, 20 angebracht sind. Ein vierter resistiver Näherungssensor 12^{III} befindet sich zwischen Ringfinger 20 und kleinem Finger 21 mit jeweils einer Komponente A^{III}, B^{III} an beiden Fingern. Bei der Annäherung des Daumens 16 an den Zeige-, Mittel- oder Ringfinger 15, 17, 20 wird der betreffende Finger durch den betreffenden resistiven Näherungssensor 12, 12^{I}, 12" identifiziert, sodass bei der anschließenden Ausübung von Druck auf den Daumen 16 drei verschiedene technische Funktionen gesteuert werden können. So lassen sich z.B. mit den drei Fingern die Helligkeiten von drei Lampen mit verschiedenen Farben individuell einstellen. Durch den vierten resistiven Näherungssensor 12^{III} zwischen Ringfinger 20 und kleinem Finger 21 kann der jeweils eingestellte Helligkeitswert über die Schaltfunktion übernommen und gespeichert werden.

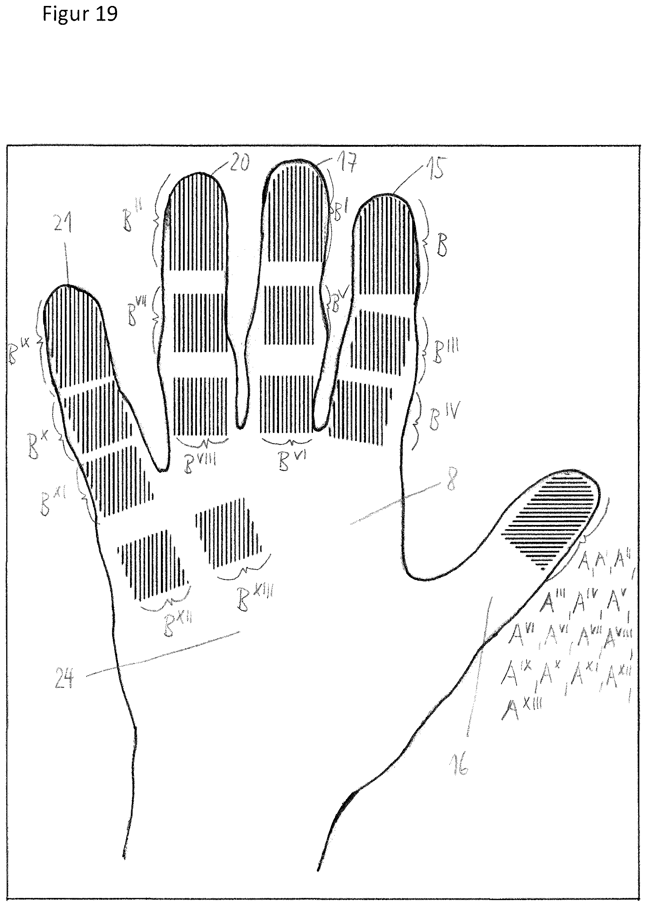

Figur 19 zeigt ein erfindungsgemäßes Handbedienelement als Handschuh mit insgesamt 14 kapazitiven Näherungssensoren (als schraffierte Flächen dargestellt), deren gemeinsame eine Komponente A, A^{I}, A", A^{III}, A^{IV}, A^{V}, A^{VI}, A^{VII}, A^{VIII}, A^{IX}, A^{X}, A^{XI}, A^{XII}, A^{XIII} auf der Innenseite des Daumens 16 und deren anderen Komponenten B, B^{I}, B^{II}, B^{III}, B^{IV}, B^{V}, B^{VI}, B^{VII}, B^{VIII}, B^{IX}, B^{X}, B^{XI}, B^{XII}, B^{XIII} auf den Innenseiten der anderen Finger 15, 17, 20, sowie auf der Hand-Innenfläche 24 angebracht sind. Bei der Annäherung und Berührung der Komponente A, A^{I}, A^{II}, A^{III}, A^{IV}, A^{V}, A^{VI}, A^{VII}, A^{VIII}, A^{IX}, A^{X}, A^{XI}, A^{XII}, A^{XIII} auf dem Daumen 16 an die anderen Komponenten B, B^{I}, B^{II}, B^{III}, B^{IV}, B^{V}, B^{VI}, B^{VII}, B^{VIII}, B^{IX}, B^{X}, B^{XI}, B^{XII}, B^{XIII} auf den anderen Fingern 15, 17, 20, 21 bzw. auf der Hand-Innenfläche 24 werden durch die gemessene Kapazitätsveränderung unterschiedliche Schaltvorgänge ausgelöst. Damit lassen sich z. B. Ziffern oder Buchstaben für einen Code eingeben.

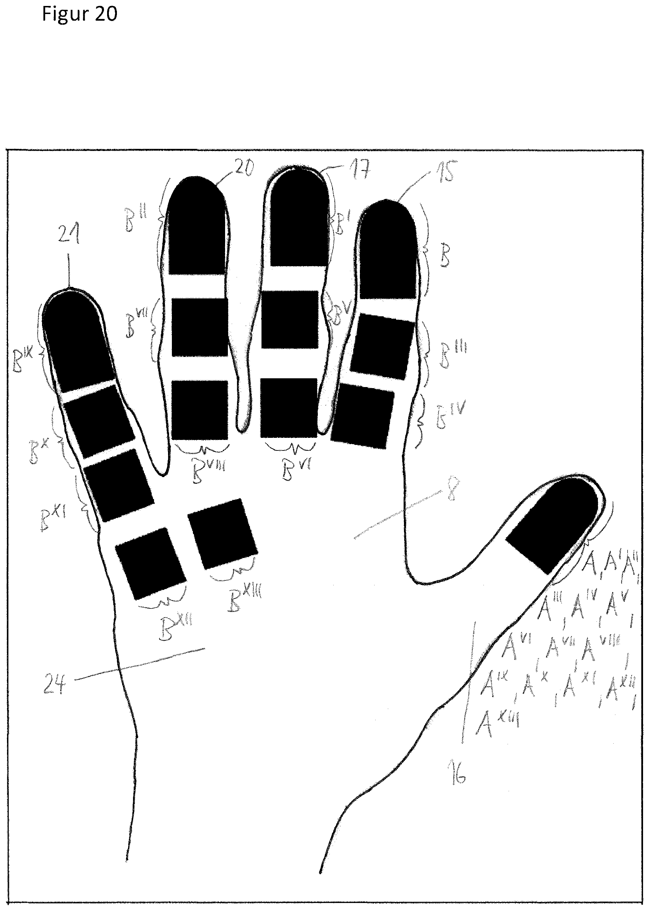

Figur 20 zeigt ein erfindungsgemäßes Handbedienelement als Handschuh mit insgesamt 14 resistiven Näherungssensoren (als schwarze Flächen dargestellt), deren gemeinsame eine Komponente A, A^{I}, A^{II}, A^{III}, A^{IV}, A^{V}, A^{VI}, A^{VII}, A^{VIII}, A^{IX}, A^{X}, A^{XI}, A^{XII}, A^{XIII} auf der Innenseite des Daumens 16 und deren anderen Komponenten B, B^{I}, B^{II}, B^{III}, B^{IV}, B^{V}, B^{VI}, B^{VII}, B^{VIII}, B^{IX}, B^{X}, B^{XI}, B^{XII}, B^{XIII} auf den Innenseiten der anderen Finger 15, 17, 20, sowie auf der Hand-Innenfläche 24 angebracht sind. Bei der Annäherung und Berührung der Komponente A, A^{VIII}, A^{IX}, A^{X}, A^{XI}, A^{XII}, A^{XIII} auf dem Daumen an die A^{I}, A^{II}, A^{III}, A^{IV}, A^{V}, A^{VI}, A^{VII}, A^{VIII}, anderen Komponenten B, B^{I}, B^{II}, B^{III}, B^{IV}, B^{V}, B^{VI}, B^{VII}, B^{VIII}, B^{IX}, B^{X}, B^{XI}, B^{XII}, B^{XIII} auf den anderen Fingern 15, 17, 20, 21 bzw. auf der Hand-Innenfläche 24 werden durch die gemessene Widerstandsveränderung unterschiedliche Schaltvorgänge ausgelöst. Damit lassen sich z. B. Ziffern oder Buchstaben für einen Code eingeben.

### Beispiel 1 - Steuerfunktion eines resistiven Drucksensors

Ein resistiver Drucksensor enthält mindestens zwei leitfähige Elektrodenschichten (vorzugsweise ein Elastomer enthaltend), deren Flächen mindestens teilweise übereinander liegend angeordnet sind, wobei sich der elektrische Widerstand zwischen den mindestens zwei leitfähigen Elektrodenschichten beim zusammendrücken des Drucksensors messbar verändert. Der resistive Drucksensor hat vorzugsweise einen Aufbau aus zwei leitfähigen Elastomerschichten, von denen mindestens eine auf der der anderen Elastomerschicht zugewandten Seite eine profilierte Oberfläche aufweist. Beim Zusammendrücken der beiden Bauteile gegeneinander verformt sich die profilierte Oberfläche derart, dass die Kontaktfläche zwischen den beiden Elastomerschichten zunimmt und der elektrische Widerstand zwischen den beiden Elastomerschichten abnimmt. Der Drucksensor kann sich in einer Zone des Handschuhs befinden, die von der Innenseite des Daumens eines Benutzers umschlossen wird.

In der Steuerfunktion wird der elektrische Widerstand beispielsweise durch den mit einem anderen Finger auf den Daumen ausgeübten Druck stufenlos gesteuert und auf einen gewünschten Wert eingestellt. Er dient damit als stufenlose Steuergröße für die elektrisch steuerbare Vorrichtung.

In der Schaltfunktion wird der gemessene elektrische Widerstand dazu benutzt, um einen Vorgang auszulösen. Das Auslösen erfolgt dadurch, dass der Widerstand einen bestimmten Wert annimmt, sich in einem bestimmten Bereich befindet oder eine bestimmte zeitliche Veränderung erfährt.

### Beispiel 2 - Steuerfunktion eines resistiven Näherungssensors

Ein resistiver Näherungssensor enthält eine leitfähige Elektrodenschicht (vorzugsweise ein Elastomer enthaltend) in einer ersten Zone des Handschuhs und eine zweite leitfähige Elektrodenschicht (vorzugsweise ein Elastomer enthaltend) in einer zweiten Zone des Handschuhs, wobei sich der elektrische Widerstand zwischen den leitfähigen Elektrodenschichten beim Annähern, Berühren und Zusammendrücken der beiden leitfähigen Elektrodenschichten messbar verändert. Der resistive Näherungssensor befindet sich also in zwei Zonen des Handschuhs, z.B. in einer Zone, welche die Innenseite eines Fingerglieds umschließt und in einer Zone, welche die Innenseite des Daumens umschließt.

In der Steuerfunktion wird der elektrische Widerstand beispielsweise durch die Annäherung des Daumens an den anderen Finger über die Berührung und Druckausübung mit ansteigender Kontaktfläche stufenlos gesteuert und auf einen gewünschten Wert eingestellt. Er dient damit als stufenlose Steuergröße für die elektrisch steuerbare Vorrichtung.

In der Schaltfunktion wird der gemessene elektrische Widerstand bei der Berührung dazu benutzt, um einen Vorgang auszulösen. Das Auslösen erfolgt dadurch, dass der Widerstand einen bestimmten Wert annimmt, sich in einem bestimmten Bereich befindet oder eine bestimmte zeitliche Veränderung erfährt.

### Beispiel 3 - Steuerfunktion eines resistiven Schersensors

### 1. eindimensionaler resistiver Schersensor

Ein resistiver Schersensor enthält mindestens zwei leitfähigen Elektrodenschichten (vorzugsweise ein Elastomer enthaltend) in einer ersten Zone des Handschuhs, wobei die leitfähigen Elektrodenschichten (zumindest teilweise) nebeneinander liegen, und eine dritte leitfähige Elektrodenschicht (vorzugsweise ein Elastomer enthaltend) in einer zweiten Zone des Handschuhs, wobei sich die elektrischen Widerstände zwischen den mindestens zwei leitfähigen Elektrodenschichten in der ersten Zone und der weiteren Elektrodenschicht in der zweiten Zone bei der Scherbewegung zwischen den mindestens zwei Handzonen messbar verändern. Der resistive Schersensor befindet sich also in mindestens zwei Zonen des Handschuhs, z.B. auf einer Zone, welche die Innenseite mindestens eines Fingers umschließt und eine Zone, welche die Innenseite des Daumens umschließt.

In der Steuerfunktion werden die elektrischen Widerstände beispielsweise durch die Scherbewegung des Daumens an dem anderen Finger stufenlos gesteuert und auf gewünschte Werte eingestellt. Sie dienen damit als stufenlose Steuergrößen für die elektrisch steuerbare Vorrichtung.

In der Schaltfunktion werden die gemessenen elektrischen Widerstände dazu benutzt, um einen Vorgang auszulösen. Das Auslösen erfolgt dadurch, dass die Widerstände oder mathematische Funktionen daraus bestimmte Werte annehmen, sich in einem bestimmten Bereich befinden oder bestimmte zeitliche Veränderungen erfahren.

Bei diesem resistiven Schersensor kann bei zwei leitfähigen Elektrodenschichten auf einer Zone des Handschuhs (z.B. Innenfläche eines Fingers) und einer weiteren leitfähigen Elektrodenschicht auf einer weiteren Zone des Handschuhs (z. B. Innenfläche des Daumens) eine eindimensionale Scherbewegung zwischen dem Finger und dem Daumen ausgeführt werden, bei der sich die beiden elektrischen Leitfähigkeiten zwischen jeweils einer leitfähigen Elektrodenschicht auf dem Finger und der weiteren leitfähigen Elektrodenschicht auf dem Daumen derart verändern, dass die eine elektrische Leitfähigkeit zunimmt und die andere elektrische Leitfähigkeit abnimmt.

Daraus folgt, dass die Differenz der beiden elektrischen Leitfähigkeiten abhängig von der Richtung der Scherbewegung abnimmt oder zunimmt. Wegen der eindimensionalen Scherbewegung wird hier von einem eindimensionalen Schersensor gesprochen.

### 2. mehrdimensionaler resistiver Schersensor

Beim zweidimensionalen Schersensor befinden sich vier leitfähige Elektrodenschichten auf einer Zone des Handschuhs (z.B. ein Finger) oder auf zwei Zonen des Handschuhs (z. B. zwei Finger) und eine weitere leitfähige Elektrodenschicht auf einer weiteren Zone des Handschuhs (z. B. Daumen). Zwischen den vier leitfähigen Elektrodenschichten auf dem Finger bzw. auf den Fingern und der weiteren leitfähigen Elektrodenschicht auf dem Daumen entstehen vier messbare elektrische Widerstände, die kontinuierlich gemessen werden. In dieser Anordnung kann die Elektrodenfläche des Daumens über die vier anderen Elektrodenflächen geschert werden, wobei sich die vier gemessenen Widerstandswerte positionsabhängig verändern. Damit wird eine zweidimensionale Positionsbestimmung des Daumens möglich. Ein solches zweidimensionales resistives Scherelement kann damit die Funktion einer Computer-Maus übernehmen und die Bewegung des Cursors auf einem Bildschirm steuern.

### Beispiel 4 - Steuerfunktion eines kapazitiven Drucksensors

Ein kapazitiver Drucksensor enthält mindestens zwei leitfähigen Elektrodenschichten (vorzugsweise ein Elastomer enthaltend), deren Flächen mindestens teilweise übereinander angeordnet sind, sowie mit mindestens einer nicht leitfähigen Dielektrikumsschicht (vorzugsweise ein Elastomer enthaltend) zwischen den mindestens zwei leitfähigen Elektrodenschichten, wobei sich die elektrische Kapazität zwischen den mindestens zwei leitfähigen Elektrodenschichten beim Zusammendrücken des Drucksensors messbar verändert. Der kapazitive Drucksensor hat vorzugsweise einen Aufbau wie in der EP 2 698 616 A2 bzw. DE 10 2014 201 434 A1 beschrieben. Der kapazitive Drucksensor befindet sich in einer Zone des Handschuhs, die von der Innenseite des Daumens umschlossen wird.

In der Steuerfunktion wird die Kapazität beispielsweise durch den mit einem anderen Finger auf den Daumen ausgeübten Druck stufenlos gesteuert und auf einen gewünschten Wert eingestellt. Die Kapazität dient damit als stufenlose Steuergröße für die elektrisch steuerbare Vorrichtung.

In der Schaltfunktion wird die gemessene Kapazität dazu benutzt, um einen Vorgang auszulösen. Das Auslösen erfolgt dadurch, dass die Kapazität einen bestimmten Wert annimmt, sich in einem bestimmten Bereich befindet oder eine bestimmte zeitliche Veränderung erfährt.

### Beispiel 5 - Steuerfunktion eines kapazitiven Näherungssensors

Ein kapazitiver Näherungssensor enthält eine leitfähige Elektrodenschicht (vorzugsweise ein Elastomer enthaltend) in einer ersten Zone, eine zweite leitfähigen Elektrodenschicht (vorzugsweise ein Elastomer enthaltend) in einer zweiten Zone, sowie eine nicht-leitfähige Dielektrikumsschicht (vorzugsweise ein Elastomer enthaltend) auf mindestens einer der leitfähigen Elektrodenschichten, wobei sich die elektrische Kapazität zwischen den leitfähigen Elektrodenschichten beim Annähern der beiden leitfähigen Elektrodenschichten messbar verändert. Der kapazitive Sensor befindet sich also in zwei Zonen des Handschuhs, z.B. in einer Zone, welche die Innenseite eines Fingerglieds umschließt und einer Zone, welche die Innenseite des Daumens umschließt.

In der Steuerfunktion wird die elektrische Kapazität beispielsweise durch die Annäherung des Daumens an den anderen Finger bis zur Berührung stufenlos gesteuert und auf einen gewünschten Wert eingestellt. Sie dient damit als stufenlose Steuergröße für die elektrisch steuerbare Vorrichtung.

In der Schaltfunktion wird die gemessene elektrische Kapazität dazu benutzt, um einen Vorgang auszulösen. Das Auslösen erfolgt dadurch, dass die Kapazität einen bestimmten Wert annimmt, sich in einem bestimmten Bereich befindet oder eine bestimmte zeitliche Veränderung erfährt.

### Beispiel 6 - Steuerfunktion eines kapazitiven Schersensors

### 1. eindimensionaler kapazitiver Schersensor

Ein kapazitiver Schersensor enthält mindestens zwei leitfähige Elektrodenschichten (vorzugsweise ein Elastomer enthaltend) in einer ersten Zone, wobei die Elektrodenschichten (zumindest teilweise) nebeneinander liegen, eine weitere elektrisch leitfähige Elektrodenschicht (vorzugsweise ein Elastomer enthaltend) in einer zweiten Zone, sowie einer nicht-leitfähigen Dielektrikumsschicht (vorzugsweise ein Elastomer enthaltend) auf mindestens einer der leitfähigen Elektrodenschichten, wobei sich die elektrischen Kapazitäten zwischen den mindestens zwei leitfähigen Elektrodenschichten in der ersten Zone und der weiteren Elektrodenschicht in der zweiten Zone bei der Scherbewegung zwischen den mindestens zwei Handzonen messbar verändern. Der kapazitive Schersensor befindet sich also in mindestens zwei Zonen des Handschuhs, z.B. in einer Zone, welche die Innenseite mindestens eines Fingers umschließt und eine weitere Zone, welche die Innenseite des Daumens umschließt.

In der Steuerfunktion werden die elektrischen Kapazitäten beispielsweise durch die Scherbewegung des Daumens an dem anderen Finger stufenlos gesteuert und auf gewünschte Werte eingestellt. Sie dienen damit als stufenlose Steuergrößen für die elektrisch steuerbare Vorrichtung.

In der Schaltfunktion werden die gemessenen elektrischen Kapazitäten dazu benutzt, um einen Vorgang auszulösen. Das Auslösen erfolgt dadurch, dass die Kapazitäten oder mathematische Funktionen daraus bestimmte Werte annehmen, sich in einem bestimmten Bereich befinden oder bestimmte zeitliche Veränderungen erfahren.

Bei diesem kapazitiven Schersensor kann bei zwei leitfähigen Elektrodenschichten auf einer Zone des Handschuhs (z.B. Innenfläche eines Fingers) und einer weiteren leitfähigen Elektrodenschicht auf einer weiteren Zone des Handschuhs (z. B. Innenfläche des Daumens) eine eindimensionale Scherbewegung zwischen dem Finger und dem Daumen ausgeführt werden, bei der sich die beiden elektrischen Kapazitäten zwischen jeweils einer leitfähigen Elektrodenschicht auf dem Finger und der weiteren leitfähigen Elektrodenschicht auf dem Daumen derart verändern, dass die eine elektrische Kapazität zunimmt und die andere elektrische Kapazität abnimmt.

Daraus folgt, dass die Differenz der beiden elektrischen Kapazitäten abhängig von der Richtung der Scherbewegung abnimmt oder zunimmt. Wegen der eindimensionalen Scherbewegung wird hier von einem eindimensionalen Schersensor gesprochen.

### 2. mehrdimensionaler kapazitiver Schersensor

Beim zweidimensionalen Schersensor befinden sich vier leitfähige Elektrodenschichten auf einer Zone des Handschuhs (z.B. ein Finger) oder auf zwei Zonen des Handschuhs (z. B. zwei Finger) und eine weitere leitfähige Elektrodenschicht auf einer weiteren Zone des Handschuhs (z. B. Daumen). Zwischen den vier leitfähigen Elektrodenschichten auf dem Finger bzw. auf den Fingern und der weiteren leitfähigen Elektrodenschicht auf dem Daumen befindet sich noch mindestens eine Dielektrikumschicht Folglich entstehen vier messbare elektrische Kapazitäten, die kontinuierlich gemessen werden. In dieser Anordnung kann die Elektrodenfläche des Daumens über die vier anderen Elektrodenflächen geschert werden, wobei sich die vier gemessenen Kapazitätswerte positionsabhängig verändern. Damit wird eine zweidimensionale Positionsbestimmung des Daumens möglich. Ein solches zweidimensionales resistives Scherelement kann damit die Funktion einer Computer-Maus übernehmen und die Bewegung des Cursors auf einem Bildschirm steuern.

### Bezugszeichenliste

- 1, 1^{I}:: erste elektrisch leitfähige Elektrodenschicht;
- 2:: zweite elektrisch leitfähige Elektrodenschicht;
- 3, 3^{I}, 3":: Dielektrikumschicht;
- 4:: Noppenprofil;
- 5, 5^{I}, 5":: elektrisch leitfähige Elektrodenschicht zur Abschirmung gegenüber dem Oberflächenpotential der Haut;
- 6, 6^{I}, 6":: Dielektrikumschicht zur Abschirmung gegenüber Oberflächenpotential der Haut;
- 7: dritte elektrisch leitfähige Elektrodenschicht;
- 8:: Handbedienelement (z.B. Handschuh);
- 9:: kapazitiver Drucksensor;
- 10:: resistiver Drucksensor;
- 11, 11^{I}, 11":: kapazitiver Näherungssensor;
- 12, 12^{I}, 12":: resistiver Näherungssensor;
- 13:: kapazitiver Schersensor;
- 14:: resistiver Schersensor;
- 15:: Zeigefinger;
- 16:: Daumen;
- 17:: Mittelfinger;
- 18:: zweidimensionaler kapazitiver Schersensor;
- 19:: zweidimensionaler resistiver Schersensor;
- 20:: Ringfinger;
- 21:: kleiner Finger;
- 22:: vierte elektrisch leitfähige Elektrodenschicht;
- 23:: fünfte elektrisch leitfähige Elektrodenschicht;
- 24:: Handinnenseite;
- A, A^{I}, A^{II}, A^{III}, A^{IV}, A^{V}, A^{VI}, A^{VII}, A^{VIII}, A^{IX}, A^{X}, A^{XI}, A^{XII}, A^{XIII}:: 1. Teil vom mindestens einen Sensor;
- B, B^{I}, B^{II}, B^{III}, B^{IV}, B^{V}, B^{VI}, B^{VII}, B^{VIII}, B^{IX}, B^{X}, B^{XI}, B^{XII}, B^{XIII}:: 2. Teil von mindestens einem Sensor;
- C:: 3. Teil von mindestens einem Sensor;
- D:: 4. Teil von mindestens einem Sensor;
- E:: 5. Teil von mindestens einem Sensor.

## Patentansprüche

1. Flexibles, tragbares Handbedienelement (8) zur Steuerung einer elektrisch steuerbaren Vorrichtung, enthaltend
a) mindestens einen Sensor (11, 11^{I}, 11^{II} 13, 18, 12, 12^{I}, 12^{II} 14, 19), wobei der mindestens eine Sensor (11, 11^{I}, 11^{II}, 13, 18, 12, 12^{I}, 12^{II}, 14, 19) zur Detektion von elektrischen Widerständen geeignet ist, ausgewählt ist aus der Gruppe bestehend aus resistiver Näherungssensor (12, 12^{I}, 12^{II}), resistiver Schersensor (14, 19) und Kombinationen hiervon, und eine erste (1, 1^{I}) und eine zweite (2) elektrisch leitfähige Elektrodenschicht aufweist, wobei die zweite Elektrodenschicht (2) in einer Zone des tragbaren Handbedienelements (8) angeordnet ist, die verschieden ist zu einer Zone des tragbaren Handbedienelements (8), in welcher die erste Elektrodenschicht (1, 1^{I}) angeordnet ist, wobei die zweite Elektrodenschicht (2) dazu geeignet ist, durch eine Bewegung des Handbedienelements (8) über die erste Elektrodenschicht (1, 1^{I}) angeordnet zu werden; und/oder
wobei der mindestens eine Sensor (11, 11^{I}, 11", 13, 18, 12, 12^{I}, 12", 14, 19) zur Messung von elektrischen Kapazitäten geeignet ist, ausgewählt ist aus der Gruppe bestehend aus kapazitiver Näherungssensor (11, 11^{I}, 11"), kapazitiver Schersensor (13, 18) und Kombinationen hiervon, und eine erste (1, 1^{I}) und eine zweite elektrisch leitfähige Elektrodenschicht (2) und eine Dielektrikumschicht (3, 3^{I}, 3^{II}) aufweist, wobei die zweite Elektrodenschicht (2) in einer Zone des tragbaren Handbedienelements (8) angeordnet ist, die verschieden ist zu einer Zone des tragbaren Handbedienelements (8), in welcher die erste Elektrodenschicht (1, 1^{I}) angeordnet ist, wobei die zweite Elektrodenschicht (2) dazu geeignet ist, durch eine Bewegung des Handbedienelements (8) über die erste Elektrodenschicht (1, 1^{I}) dergestalt angeordnet zu werden, dass die Dielektrikumschicht (3, 3^{I}, 3") zwischen der ersten (1, 1^{I}) und zweiten Elektrodenschicht (2) angeordnet ist;
b) eine elektronische Steuerungseinheit, die dazu konfiguriert ist, mindestens eine vom Sensor (11, 11^{I}, 11", 13, 18, 12, 12^{I}, 12", 14, 19) detektierte elektrische Kapazität und/oder mindestens einen vom Sensor (11, 11^{I}, 11", 13, 18, 12, 12^{I}, 12", 14, 19) detektierten elektrischen Widerstand in ein Steuersignal zur Steuerung der elektrisch steuerbaren Vorrichtung umzuwandeln; und
c) eine Kommunikationsschnittstelle, die dazu konfiguriert ist, ein Steuersignal der elektronischen Steuerungseinheit an die elektrisch steuerbare Vorrichtung zu senden,
wobei das tragbare Handbedienelement (8) eine erste Zone und eine zweite Zone aufweist, wobei die erste und zweite Zone jeweils zur zumindest teilweisen Bedeckung eines Fingers (15, 16, 17, 20, 21) oder einer Handinnenfläche (24) eines Benutzers geeignet sind, an unterschiedlichen Stellen des Handbedienelements angeordnet sind und für die Herstellung eines Steuersignals nötig sind, wobei der mindestens eine Sensor (11, 11^{I}, 11", 13, 18, 12, 12^{I}, 12", 14, 19) teilweise in der ersten Zone und teilweise in der zweiten Zone angeordnet ist, wobei die erste Zone zur zumindest teilweisen Bedeckung einer Fläche eines ersten Fingers (15, 16, 17, 20, 21) eines Benutzers geeignet ist und die zweite Zone zur zumindest teilweisen Bedeckung einer Fläche eines zweiten Fingers (15, 16, 17, 20, 21), oder der Handinnenfläche (24), derselben Hand eines Benutzers geeignet ist,
wobei für den Fall, dass der mindestens eine Sensor (11, 11^{I}, 11", 13, 18, 12, 12^{I}, 12", 14, 19) ein kapazitiver Schersensor (13, 18) oder ein resistiver Schersensor (14, 19) ist, der mindestens eine Sensor (11, 11^{I}, 11", 13, 18, 12, 12^{I}, 12", 14, 19) ferner eine dritte elektrisch leitfähige Elektrodenschicht (7) aufweist, die in einer Zone des tragbaren Handbedienelements (8) angeordnet ist, die zur zumindest teilweisen Bedeckung eines Fingers (15, 16, 17, 20, 21) oder einer Handinnenfläche (24) eines Benutzers geeignet ist und wobei diese Zone i) identisch ist mit einer Zone des tragbaren Handbedienelements (8), in welcher die erste Elektrodenschicht (1, 1^{I}) angeordnet ist, oder ii) identisch ist mit einer Zone des tragbaren Handbedienelements (8), in welcher die zweite Elektrodenschicht (2) angeordnet ist,
**dadurch gekennzeichnet, dass** der mindestens eine Sensor (11, 11^{I}, 11", 13, 18, 12, 12^{I}, 12", 14, 19) so ausgestaltet ist, dass sich bei einer Annäherung der ersten Zone an die zweite Zone bis zur Berührung, und auch bei der anschließenden Druckausübung, die Kapazität bzw. der Widerstand in definierter Weise in Abhängigkeit vom Abstand verändert.

2. Handbedienelement (8) nach Anspruch 1, **dadurch gekennzeichnet, dass** die Fläche des ersten Fingers (15, 16, 17, 20, 21) und/oder des zweiten Fingers (15, 16, 17, 20, 21) in Richtung Handinnenfläche des Benutzers ausgerichtet ist und/oder in Richtung eines Nachbarfingers (15, 16, 17, 20, 21) des Benutzers ausgerichtet ist.

3. Handbedienelement (8) nach einem der vorhergehenden Ansprüche, **dadurch gekennzeichnet, dass** die erste (1, 1^{I}) und/oder zweite (2) elektrisch leitfähige Elektrodenschicht, optional weitere Elektrodenschichten des mindestens einen Sensors (11, 11^{I}, 11", 13, 18, 12, 12^{I}, 12", 14, 19), eine profilierte Oberfläche aufweist oder mindestens einen Hohlraum zwischen der ersten (1, 1^{I}) und zweiten Elektrodenschicht (2), und optional in Richtung der Dielektrikumschicht (3, 3^{I}, 3^{II}), aufweist.

4. Handbedienelement (8) nach einem der vorhergehenden Ansprüche, **dadurch gekennzeichnet, dass**
i) die dritte Elektrodenschicht (7) neben der ersten Elektrodenschicht (1, 1^{I}) angeordnet ist und optional die Dielektrikumschicht (3, 3^{I}, 3") auf der ersten (1, 1^{I}) und dritten Elektrodenschicht (7) oder auf der zweiten Elektrodenschicht (2) angeordnet ist; oder
ii) die dritte Elektrodenschicht (7) neben der zweiten Elektrodenschicht (2) angeordnet ist und optional die Dielektrikumschicht (3, 3^{I}, 3") auf der zweiten (2) und dritten Elektrodenschicht (7) oder auf der ersten Elektrodenschicht (1, 1^{I}) angeordnet ist.

5. Handbedienelement (8) nach dem vorhergehenden Anspruch, **dadurch gekennzeichnet, dass** der mindestens eine Sensor (11, 11^{I}, 11", 13, 18, 12, 12^{I}, 12", 14, 19)
i) eine vierte (22), optional noch weitere (23), elektrisch leitfähige Elektrodenschicht(en) aufweist, die bevorzugt neben der ersten (1, 1^{I}) und/oder dritten Elektrodenschicht (7) angeordnet sind; und/oder
ii) eine weitere Dielektrikumsschicht (3, 3^{I}, 3"), optional mehrere weitere Dielektrikumsschichten (3, 3^{I}, 3"), aufweist; und/oder
iii) eine elektrische Abschirmschicht (5, 5^{I}, 5", 6, 6^{I}, 6") enthält, die auf dem mindestens einen Sensor (11, 11^{I}, 11", 13, 18, 12, 12^{I}, 12", 14, 19) in Richtung einer Fläche einer Hand eines Benutzers angeordnet ist, wobei die Abschirmschicht (5, 5^{I}, 5", 6, 6^{I}, 6") bevorzugt eine elektrisch leitfähige Elektrodenschicht (5, 5^{I}, 5") und eine Dielektrikumschicht (6, 6^{I}, 6") enthält oder daraus besteht und die elektrisch leitfähige Elektrodenschicht (5, 5^{I}, 5") in Richtung einer Fläche einer Hand eines Benutzers angeordnet ist.

6. Handbedienelement (8) nach einem der vorhergehenden Ansprüche, **dadurch gekennzeichnet, dass** das tragbare Handbedienelement (8) ein elektrisch nicht-leitfähiges Material enthält, bevorzugt ein elektrisch nicht-leitfähiges Material ausgewählt aus der Gruppe bestehend aus Textil, Leder, Kunstleder, Kunststoff und Kombinationen hiervon, besonders bevorzugt einen Kunststoff, ganz besonders bevorzugt einen elastomeren Kunststoff, wobei der elastomere Kunststoff insbesondere ausgewählt ist aus der Gruppe bestehend aus
i) Silikon, Fluorsilicon, Polyurethan, Polynorbornen, Kautschuk, Naturkautschuk, Fluorkautschuk, Styrol-Butadien, Isobutylen-Isopren, Ethylen-Propylen-Dien-Terpolymer, Poly-Chlorbutadien, chlorsulfoniertes Polyethylen, Acrylnitril-Butadien, hydriertes Acrylnitril-Butadien und Kombinationen hiervon;
ii) thermoplastische Styrol-Copolymere, besonders bevorzugt ausgewählt aus der Gruppe bestehend aus Styrol-Butadien-Styrol-Copolymer, Styrol-Ethylen-Butadien-Styrol-Copolymer, Styrol-Ethylen-Propylen-Styrol-Copolymer, Styrol-Ethylen-Ethylen-Propylen-Styrol-Copolymer, Styrol-Isopren-Styrol-Copolymer und Kombinationen hiervon;
iii) teilvernetzte Mischungen auf Polyolefin-Basis, bevorzugt ausgewählt aus der Gruppe bestehend aus Ethylen-Propylen-Dien-Kautschuk und Polypropylen, Nitril-Butadien-Kautschuk und Polypropylen, Ethylen-Propylen-Dien-Kautschuk und Polyethylen und Kombinationen hiervon;
iv) thermoplastische Urethan-Copolymere, bevorzugt ausgewählt aus der Gruppe bestehend aus TPU-ARES, TPUARET, TPU-AREE und Kombinationen hiervon; und
v) Kombinationen hiervon.

7. Handbedienelement (8) nach einem der vorhergehenden Ansprüche, **dadurch gekennzeichnet, dass** die erste elektrisch leitfähige Elektrodenschicht (1, 1^{I}), die zweite elektrisch leitfähige Elektrodenschicht (2) und/oder die Dielektrikumschicht (3, 3^{I}, 3"), optional weitere Elektrodenschichten (7, 22, 23) und/oder Dielektrikumschichten (3, 3^{I}, 3") des mindestens einen Sensors (11, 11^{I}, 11", 13, 18, 12, 12^{I}, 12", 14, 19), ein elektrisch nicht-leitfähiges Material enthält, bevorzugt einen Kunststoff, besonders bevorzugt einen elastomeren Kunststoff, ganz besonders bevorzugt einen elastomeren Kunststoff ausgewählt aus der Gruppe bestehend aus
i) Silikon und seine Derivate, Polyurethan, Polynorbornen, Kautschuk, Naturkautschuk, Fluorkautschuk, Styrol-Butadien, Isobutylen-Isopren, Ethylen-Propylen-Dien-Terpolymer, Poly-Chlorbutadien, chlorsulfoniertes Polyethylen, Acrylnitril-Butadien, hydriertes Acrylnitril-Butadien und Kombinationen hiervon, bevorzugt Silikon und seine Derivate;
ii) thermoplastische Styrol-Copolymere, besonders bevorzugt ausgewählt aus der Gruppe bestehend aus Styrol-Butadien-Styrol-Copolymer, Styrol-Ethylen-Butadien-Styrol-Copolymer, Styrol-Ethylen-Propylen-Styrol-Copolymer, Styrol-Ethylen-Ethylen-Propylen-Styrol-Copolymer, Styrol-Isopren-Styrol-Copolymer und Kombinationen hiervon;
iii) teilvernetzte Mischungen auf Polyolefin-Basis, bevorzugt ausgewählt aus der Gruppe bestehend aus Ethylen-Propylen-Dien-Kautschuk und Polypropylen, Nitril-Butadien-Kautschuk und Polypropylen, Ethylen-Propylen-Dien-Kautschuk und Polyethylen und Kombinationen hiervon;
iv) thermoplastische Urethan-Copolymere, bevorzugt ausgewählt aus der Gruppe bestehend aus TPU-ARES, TPUARET, TPU-AREE und Kombinationen hiervon; und
v) Kombinationen hiervon.

8. Handbedienelement (8) nach einem der vorhergehenden Ansprüche, **dadurch gekennzeichnet, dass** die erste elektrisch leitfähige Elektrodenschicht (1, 1^{I}) und/oder die zweite elektrisch leitfähige Elektrodenschicht (2), optional weitere Elektrodenschichten (7, 22, 23) des mindestens einen Sensors (11, 11^{I}, 11", 13, 18, 12, 12^{I}, 12", 14, 19), ein elektrisch leitfähiges Material enthält, bevorzugt ein Material ausgewählt aus der Gruppe bestehend aus Kohlenstoff, Metall, Halbmetall, elektrisch leitfähiger Kunststoff und Mischungen hiervon, besonders bevorzugt ein Material ausgewählt aus der Gruppe bestehend aus Ruß, Graphit, Graphen, Kohlenstoffnanoröhrchen, Eisen, Kupfer, Silber, Gold, Polyanilin, Polyacetylen, Polypyrrol, Polyparaphenylen, Polythiophen und Kombinationen hiervon, wobei das Material ganz besonders bevorzugt in einer anisotropen Form vorliegt, insbesondere in einer Form ausgewählt aus der Gruppe bestehend aus Partikeln, Plättchen, Stäbchen, Fasern und Kombinationen hiervon.

9. Handbedienelement (8) nach einem der vorhergehenden Ansprüche, **dadurch gekennzeichnet, dass** die Dielektrikumschicht (3, 3^{I}, 3") ein elektrisch polarisierbares Material enthält, bevorzugt ein Material ausgewählt aus der Gruppe bestehend aus Bariumtitanat, Bleizirkonattitanat, Titandioxid und Mischungen hiervon, wobei das Material ganz besonders bevorzugt in einer anisotropen Form vorliegt, insbesondere in einer Form ausgewählt aus der Gruppe bestehend aus Partikeln, Plättchen, Stäbchen, Fasern und Kombinationen hiervon.

10. Handbedienelement (8) nach einem der vorhergehenden Ansprüche, **dadurch gekennzeichnet, dass** die elektronische Steuerungseinheit dazu konfiguriert ist, eine vom Sensor (11, 11^{I}, 11", 13, 18, 12, 12^{I}, 12", 14, 19) detektierte elektrische Kapazität und/oder einen vom Sensor (11, 11^{I}, 11", 13, 18, 12, 12^{I}, 12", 14, 19) detektierten elektrischen Widerstand in
i) eine stufenlose Steuergröße zur stufenlosen Steuerung einer elektrisch steuerbaren Vorrichtung umzuwandeln; und/oder
ii) eine gestufte Steuergröße zur gestuften Schaltung einer elektrisch steuerbaren Vorrichtung, bevorzugt eine binäre Steuergröße zur binären Schaltung einer elektrisch steuerbaren Vorrichtung, umzuwandeln, wobei die elektronische Steuerungseinheit bevorzugt dazu konfiguriert ist,
die Umwandlung in die gestufte Steuergröße durch einen Vergleich mindestens eines vom Sensor (11, 11^{I}, 11", 13, 18, 12, 12^{I}, 12", 14, 19) detektierten Werts für die elektrische Kapazität und/oder den elektrischen Widerstand mit mindestens einem Schwellenwert vorzunehmen, insbesondere basierend auf einem Überschreiten oder Unterschreiten von einem Schwellenwert oder basierend auf einer Bestimmung, ob der mindestens eine vom Sensor (11, 11^{I}, 11", 13, 18, 12, 12^{I}, 12", 14, 19) detektierte Wert in einem Intervall zwischen zwei Schwellenwerten liegt und/oder
die Umwandlung in die gestufte Steuergröße durch Berücksichtigung von einem oder mehreren vom Sensor (11, 11^{I}, 11", 13, 18, 12, 12^{I}, 12", 14, 19) detektierten Wert(en) für die elektrische Kapazität und/oder den elektrischen Widerstand in einer mathematischen Funktion vorzunehmen; und/oder
iii) ein Signal zur Übernahme einer bestimmten stufenlosen oder gestuften Steuergröße von der elektrischen Vorrichtung umzuwandeln.

11. Handbedienelement (8) nach einem der vorhergehenden Ansprüche, **dadurch gekennzeichnet, dass** die Kommunikationsschnittstelle dazu konfiguriert ist, das Steuersignal der elektronischen Steuerungseinheit kabellos an eine elektrisch steuerbare Vorrichtung zu senden, bevorzugt über ein kabelloses Signal ausgewählt aus der Gruppe bestehend aus Bluetooth, WLAN, ZigBee, Z-Wave, Thread, 2G, 3G, 4G, 5G, LTE und Kombinationen hiervon.

12. Kit enthaltend ein Handbedienelement (8) nach einem der vorherigen Ansprüche und eine elektrisch steuerbare Vorrichtung, wobei die elektrisch steuerbare Vorrichtung dazu konfiguriert ist, mindestens ein Steuersignal der elektronischen Steuerungseinheit des tragbaren Handbedienelements (8) zu empfangen und durch dieses gesteuert zu werden.

13. Verwendung des Handbedienelements (8) nach einem der Ansprüche 1 bis 11 zur Steuerung von einer elektrisch steuerbaren Vorrichtung, wobei es sich bei der elektrisch steuerbaren Vorrichtung bevorzugt um
i) ein Haushaltsgerät handelt, bevorzugt ein Haushaltsgerät ausgewählt aus der Gruppe bestehend aus Waschmaschine, Küchengerät, Staubsauger, Rasenmäher und Kombinationen hiervon, enthält oder daraus besteht; und/oder
ii) einen Roboter handelt, bevorzugt einen Roboter im persönlichen Bereich oder einen Industrie-Roboter; und/oder
iii) ein Straßenfahrzeug oder Wasserfahrzeug handelt, wobei die Steuerung insbesondere ein Öffnen von Türen, Schließen von Türen, eine Beleuchtung, eine Spiegeleinstellung, eine Klimatisierung, eine Navigation und/oder eine Unterhaltungselektronik betrifft; und/oder
iv) ein Flugobjekt handelt, bevorzugt eine Drohne; und/oder
v) einen Computer handelt, bevorzugt einen Computer ausgewählt aus der Gruppe bestehend aus PC, Notebook, Tablet, Smartphone und Kombinationen hiervon; und/oder
vi) eine Eingabeschnittstelle für einen Computer handelt, bevorzugt einen Joystick, eine Maus, eine Tastatur und Kombinationen hiervon; und/oder
vii) ein Logistikfahrzeug handelt; und/oder
viii) eine Produktionsmaschine handelt; und/oder
ix) ein Förderband handelt; und/oder
x) ein Unterhaltungselektronikbauteil handelt, bevorzugt ausgewählt aus der Gruppe bestehend aus Fernseher, Audioanlagen, Beamer, Kamera, MP3-Player, Lautsprecher, Kopfhörer, Spielekonsole und Kombinationen hiervon; und/oder
xi) ein Haustechnikbauteil handelt, bevorzugt ein Haustechnikbauteil ausgewählt aus der Gruppe bestehend aus Heizungsanlage, Klimaanlage, Sonnenschutzanlage und Kombinationen hiervon; und/oder
xii) eine VR/AR-Brille handelt, wobei die Steuerung insbesondere auf der VR/AR-Brille dargestellte elektronische Funktionen betrifft;
wobei die Steuerung der elektrisch steuerbaren Vorrichtung durch ein Zusammenführen der zwei Zonen des tragbaren Handbedienelements (8) erfolgt.

## Claims

1. A flexible, portable manual control element (8) for controlling an electrically controllable device, comprising
a) at least one sensor (11, 11', 11", 13,18, 12, 12', 12", 14, 19),
wherein the at least one sensor (11, 11', 11", 13, 18, 12, 12', 12", 14, 19) is suitable for detecting electrical resistances, is selected from the group consisting of resistive proximity sensor (12, 12', 12"), resistive shear sensor (14, 19) and combinations thereof, and has a first (1, 1') and a second (2) electrically conductive electrode layer, the second electrode layer (2) being arranged in a zone of the portable manual control element (8) which is different from a zone of the portable manual control element (8) in which the first electrode layer (1, 1') is arranged, the second electrode layer (2) being suitable for being arranged over the first electrode layer (1, 1') by a movement of the manual control element (8), and/or
wherein the at least one sensor (11, 11', 11", 13, 18, 12, 12', 12", 14, 19) is suitable for measuring electrical capacitances, is selected from the group consisting of capacitive proximity sensor (11, 11', 11"), capacitive shear sensor (13, 18) and combinations thereof, and has a first (1,1') and a second electrically conductive electrode layer (2) and a dielectric layer (3, 3', 3"), the second electrode layer (2) being arranged in a zone of the portable manual control element (8) which is different from a zone of the portable manual control element (8) in which the first electrode layer (1, 1') is arranged, the second electrode layer (2) being suitable for being arranged over the first electrode layer (1, 1') by a movement of the manual control element (8) such that the dielectric layer (3, 3', 3") is arranged between the first (1, 1') and second electrode layer (2);
b) an electronic control unit configured to convert at least one electrical capacitance detected by the sensor (11, 11', 11", 13, 18, 12, 12', 12", 14, 19), and/or at least one electrical resistance detected by the sensor (11, 11', 11", 13, 18, 12, 12', 12", 14, 19), into a control signal for controlling the electrically controllable device; and
c) a communication interface configured to send a control signal from the electronic control unit to the electrically controllable device,
the portable manual control unit (8) having a first zone and a second zone, wherein the first and second zones are each suitable for at least partially covering a finger (15, 16, 17, 20, 21) or a palm (24) of a user, are arranged at different sites of the manual control element and are necessary for the production of a control signal, the at least one sensor (11, 11', 11", 13, 18, 12, 12', 12", 14, 19) being arranged partially in the first zone and partially in the second zone, the first zone being suitable for at least partially covering a surface of a first finger (15, 16, 17, 20, 21) of a user and the second zone being suitable for at least partially covering a surface of a second finger (15, 16, 17, 20, 21), or the palm (24), of the same hand of a user,
wherein, in the case that the at least one sensor (11, 11', 11", 13, 18, 12, 12', 12", 14, 19) is a capacitive shear sensor (13, 18) or a resistive shear sensor (14, 19), the at least one sensor (11, 11', 11", 13, 18, 12, 12', 12", 14, 19) further has a third electrically conductive electrode layer (7) which is arranged in a zone of the portable manual control element (8) that is suitable for at least partially covering a finger (15, 16, 17, 20, 21), or a palm (24), of a user and wherein this zone i) is identical to a zone of the portable manual control element (8) in which the first electrode layer (1, 1') is arranged, or ii) is identical to a zone of the portable manual control element (8) in which the second electrode layer (2) is arranged,
**characterized in that** the at least one sensor (11, 11', 11", 13, 18, 12, 12', 12", 14, 19) is designed such that, when the first zone approaches the second zone until they touch, and also during the subsequent exertion of pressure, the capacitance or resistance changes in a defined manner depending on the distance.

2. The manual control element (8) according to claim 1, **characterized in that** the surface of the first finger (15, 16, 17, 20, 21) and/or the second finger (15, 16, 17, 20, 21) is oriented in the direction of the palm of the hand of the user and/or is oriented towards a neighboring finger (15, 16, 17, 20, 21) of the user.

3. The manual control element (8) according to any one of the preceding claims, **characterized in that** the first (1,1') and/or second (2) electrically conductive electrode layer, optionally further electrode layers of the at least one sensor (11, 11', 11", 13, 18, 12, 12', 12", 14, 19), has a profiled surface, or has at least one cavity between the first (1,1') and second electrode layer (2) and optionally towards the dielectric layer (3, 3', 3").

4. The manual control element (8) according to any one of the preceding claims, **characterized in that**
i) the third electrode layer (7) is arranged next to the first electrode layer (1, 1') and optionally the dielectric layer (3, 3', 3") is arranged on the first (1, 1') and third electrode layer (7), or on the second electrode layer (2); or
ii) the third electrode layer (7) is arranged next to the second electrode layer (2) and optionally the dielectric layer (3, 3', 3") is arranged on the second (2) and third electrode layer (7), or on the first electrode layer (1, 1').

5. The manual control element (8) according to the preceding claim, **characterized in that** the at least one sensor (11, 11', 11", 13, 18, 12, 12', 12", 14, 19)
i) has a fourth (22), optionally further (23), electrically conductive electrode layer(s), which are preferably arranged next to the first (1, 1') and/or third electrode layer (7); and/or
ii) has a further dielectric layer (3, 3', 3"), optionally a plurality of further dielectric layers (3, 3', 3"); and/or
iii) comprises an electrical shielding layer (5, 5', 5", 6, 6', 6") arranged on the at least one sensor (11, 11', 11", 13, 18, 12, 12', 12", 14, 19) in the direction of a surface of a hand of a user, wherein the shielding layer (5, 5', 5", 6, 6', 6") preferably comprises or consists of an electrically conductive electrode layer (5, 5', 5") and a dielectric layer (6, 6', 6"), and the electrically conductive electrode layer (5, 5', 5") is arranged in the direction of a surface of a hand of a user.

6. The manual control element (8) according to any one of the preceding claims, **characterized in that** the portable manual control element (8) comprises an electrically non-conductive material, preferably an electrically non-conductive material selected from the group consisting of textile, leather, imitation leather, plastic and combinations thereof, particularly preferably a plastic, very particularly preferably an elastomeric plastic, wherein the elastomeric plastic is selected in particular from the group consisting of
i) silicone, fluorosilicone, polyurethane, polynorbornene, rubber, natural rubber, fluororubber, styrene-butadiene, isobutyleneisoprene, ethylene-propylene-diene terpolymer, poly-chlorobutadiene, chlorosulfonated polyethylene, acrylonitrile-butadiene, hydrogenated acrylonitrile-butadiene, and combinations thereof;
ii) thermoplastic styrene copolymers, particularly preferably selected from the group consisting of styrene-butadiene-styrene copolymer, styrene-ethylene-butadiene-styrene copolymer, styrene-ethylene-propylene-styrene copolymer, styrene-ethylene-ethylene-propylene-styrene copolymer, styrene-isoprene-styrene copolymer and combinations thereof;
iii) partially crosslinked mixtures based on polyolefins, preferably selected from the group consisting of ethylene-propylene-diene rubber and polypropylene, nitrile-butadiene rubber and polypropylene, ethylene-propylene-diene rubber and polyethylene and combinations thereof;
iv) thermoplastic urethane copolymers, preferably selected from the group consisting of TPU-ARES, TPUARET, TPU-AREE and combinations thereof; and
v) combinations thereof.

7. The manual control element (8) according to any one of the preceding claims, **characterized in that** the first electrically conductive electrode layer (1, 1'), the second electrically conductive electrode layer (2) and/or the dielectric layer (3, 3', 3"), optionally further electrode layers (7, 22, 23) and/or dielectric layers (3, 3', 3") of the at least one sensor (11, 11', 11", 13, 18, 12, 12', 12", 14, 19), comprises an electrically non-conductive material, preferably a plastic, particularly preferably an elastomeric plastic, very particularly preferably an elastomeric plastic selected from the group consisting of
i) silicone and its derivatives, polyurethane, polynorbornene, rubber, natural rubber, fluororubber, styrene-butadiene, isobutyleneisoprene, ethylene-propylene-diene terpolymer, poly-chlorobutadiene, chlorosulfonated polyethylene, acrylonitrile-butadiene, hydrogenated acrylonitrile-butadiene and combinations thereof, preferably silicone and its derivatives;
ii) thermoplastic styrene copolymers, particularly preferably selected from the group consisting of styrene-butadiene-styrene copolymer, styrene-ethylene-butadiene-styrene copolymer, styrene-ethylene-propylene-styrene copolymer, styrene-ethylene-ethylene-propylene-styrene copolymer, styrene-isoprene-styrene copolymer and combinations thereof;
iii) partially crosslinked mixtures based on polyolefins, preferably selected from the group consisting of ethylene-propylene-diene rubber and polypropylene, nitrile-butadiene rubber and polypropylene, ethylene-propylene-diene rubber and polyethylene, and combinations thereof;
iv) thermoplastic urethane copolymers, preferably selected from the group consisting of TPU-ARES, TPUARET, TPU-AREE and combinations thereof; and
v) combinations thereof.

8. The manual control element (8) according to any one of the preceding claims, **characterized in that** the first electrically conductive electrode layer (1, 1') and/or the second electrically conductive electrode layer (2), optionally further electrode layers (7, 22, 23) of the at least one sensor (11, 11', 11", 13, 18, 12, 12', 12", 14, 19) comprises an electrically conductive material, preferably a material selected from the group consisting of carbon, metal, semimetal, electrically conductive plastic and mixtures thereof, particularly preferably a material selected from the group consisting of carbon black, graphite, graphene, carbon nanotubes, iron, copper, silver, gold, polyaniline, polyacetylene, polypyrrole, polyparaphenylene, polythiophene and combinations thereof, wherein the material is particularly preferred present in an anisotropic form, in particular in a form selected from the group consisting of particles, platelets, rods, fibers and combinations thereof.

9. The manual control element (8) according to any one of the preceding claims, **characterized in that** the dielectric layer (3, 3', 3") comprises an electrically polarizable material, preferably a material selected from the group consisting of barium titanate, lead zirconate titanate, titanium dioxide and mixtures thereof, wherein the material is very particularly preferably present in an anisotropic form, in particular in a form selected from the group consisting of particles, platelets, rods, fibers and combinations thereof.

10. The manual control element (8) according to any one of the preceding claims, **characterized in that** the electronic control unit is configured to convert an electrical capacitance detected by the sensor (11, 11', 11", 13, 18, 12, 12', 12", 14, 19), and/or an electrical resistance detected by the sensor (11,11', 11", 13, 18, 12, 12', 12", 14, 19), into
i) a stepless control variable for stepless control of an electrically controllable device; and/or
ii) a stepped control variable for the stepped switching of an electrically controllable device, preferably a binary control variable for a binary switching of an electrically controllable device, wherein the electronic control unit is preferably configured
to perform the conversion into the stepped control variable by comparing at least one value for the electrical capacitance and/or the electrical resistance detected by the sensor (11, 11', 11", 13, 18, 12, 12', 12", 14, 19) with at least one threshold value, in particular based on exceeding or falling below a threshold value, or based on a determination as to whether the at least one value detected by the sensor (11, 11', 11", 13, 18, 12, 12', 12", 14, 19) lies in an interval between two threshold values and/or
to perform the conversion into the stepped control variable by taking into account one or more value(s) for the electrical capacitance and/or the electrical resistance detected by the sensor (11, 11', 11", 13, 18, 12, 12', 12", 14, 19) in a mathematical function; and/or
iii) to convert a signal to make the electrical device adopt a specific stepless or stepped control variable .

11. The manual control element (8) according to any one of the preceding claims, **characterized in that** the communication interface is configured to wirelessly send the control signal of the electronic control unit to an electrically controllable device, preferably via a wireless signal selected from the group consisting of Bluetooth, WLAN, ZigBee, Z-Wave, Thread, 2G, 3G, 4G, 5G, LTE and combinations thereof.

12. A kit comprising a manual control element (8) according to any one of the preceding claims and an electrically controllable device, the electrically controllable device being configured to receive at least one control signal of the electronic control unit of the portable manual control element (8) and to be controlled thereby.

13. A use of the manual control element (8) according to any one of claims 1 to 11 for controlling an electrically controllable device, the electrically controllable device preferably
i) being a household appliance, preferably a household appliance selected from the group consisting of washing machine, kitchen appliance, vacuum cleaner, lawnmower and combinations thereof; and/or
ii) being a robot, preferably a personal robot or an industrial robot; and/or
iii) being a road vehicle or watercraft, the control relating in particular to opening doors, closing doors, lighting, mirror adjustment, air conditioning, navigation and/or an entertainment electronics; and/or
iv) being a flying object, preferably a drone; and/or
v) being a computer, preferably a computer selected from the group consisting of PC, notebook, tablet, smartphone and combinations thereof; and/or
vi) being an input interface for a computer, preferably a joystick, a mouse, a keyboard and combinations thereof; and/or
vii) being a logistics vehicle; and/or
viii) being a production machine; and/or
ix) being a conveyor belt; and/or
x) being an entertainment electronics component, preferably selected from the group consisting of television, audio systems, projector, camera, MP3 player, loudspeakers, headphone, game console and combinations thereof; and/or
xi) being a building services component, preferably a building services component selected from the group consisting of heating system, air conditioning system, sun protection system and combinations thereof; and/or
xii) being VR/AR glasses, the control relating in particular to electronic functions displayed on the VR/AR glasses;
the control of the electrically controllable device taking place by bringing together the two zones of the portable manual control element (8).

## Revendications

1. Elément de commande utilisateur manuelle (8) portatif flexible pour la commande d'un dispositif à commande électrique, contenant
a) au moins un capteur (11, 11', 11", 13, 18, 12, 12', 12", 14, 19),
dans lequel le au moins un capteur (11, 11', 11", 13, 18, 12, 12', 12", 14, 19) est adapté à la détection de résistances électriques, est sélectionné dans le groupe constitué d'un capteur de proximité résistif (12, 12', 12"), capteur de cisaillement résistif (14, 19) et de combinaisons de ceux-ci, et présente une première (1, 1') et une deuxième (2) couche d'électrodes électro-conductrice, dans lequel la deuxième couche d'électrodes (2) est disposée dans une zone de l'élément de commande utilisateur manuelle (8) portatif, qui est différente d'une zone de l'élément de commande utilisateur manuelle (8) portatif dans laquelle la première couche d'électrodes (1, 1') est disposée, dans lequel la deuxième couche d'électrodes (2) est adaptée à être disposée au-dessus de la première couche d'électrodes (1, 1') par un mouvement de l'élément de commande utilisateur manuelle (8) ; et/ou
dans lequel le au moins un capteur (11, 11', 11", 13, 18, 12, 12', 12", 14, 19) est adapté à la mesure de capacités électriques, est sélectionné dans le groupe constitué d'un capteur de proximité capacitif (11, 11', 11"), capteur de cisaillement capacitif (13, 18) et de combinaisons de ceux-ci, et présente une première (1, 1') et une deuxième couche d'électrodes (2) électro-conductrice et une couche diélectrique (3, 3', 3"), dans lequel la deuxième couche d'électrodes (2) est disposée dans une zone de l'élément de commande utilisateur manuelle (8) portatif, qui est différente d'une zone de l'élément de commande utilisateur manuelle (8) portatif dans laquelle la première couche d'électrodes (1, 1') est disposée, dans lequel la deuxième couche d'électrodes (2) est adaptée à être disposée au-dessus de la première couche d'électrodes (1, 1') par un mouvement de l'élément de commande utilisateur manuelle (8), de telle sorte que la couche diélectrique (3, 3', 3") est disposée entre la première (1, 1') et deuxième couche d'électrodes (2) ;
b) une unité de commande électronique, qui est configurée pour convertir au moins une capacité électrique détectée par le capteur (11, 11', 11", 13, 18, 12, 12', 12", 14, 19) et/ou au moins une résistance électrique détectée par le capteur (11, 11', 11", 13, 18, 12, 12', 12", 14, 19) en un signal de commande pour la commande du dispositif à commande électrique ; et
c) une interface de communication, qui est configurée pour envoyer un signal de commande de l'unité de commande électronique au dispositif à commande électrique,
dans lequel l'élément de commande utilisateur manuelle (8) portatif présente une première zone et une deuxième zone, dans lequel la première et deuxième zone sont adaptées respectivement à recouvrir au moins en partie un doigt (15, 16, 17, 20, 21) ou une surface intérieure de main (24) d'un utilisateur, sont disposées en différents endroits de l'élément de commande utilisateur manuelle et sont nécessaires à la production d'un signal de commande, dans lequel le au moins un capteur (11, 11', 11", 13, 18, 12, 12', 12", 14, 19) est disposé en partie dans la première zone et en partie dans la deuxième zone, dans lequel la première zone est adaptée à recouvrir au moins en partie une surface d'un premier doigt (15, 16, 17, 20, 21) d'un utilisateur et la deuxième zone est adaptée à recouvrir au moins en partie une surface d'un deuxième doigt (15, 16, 17, 20, 21), ou la surface intérieure de main (24), de la même main d'un utilisateur,
dans lequel au cas où le au moins un capteur (11, 11', 11", 13, 18, 12, 12', 12", 14, 19) serait un capteur de cisaillement capacitif (13, 18) ou un capteur de cisaillement résistif (14, 19), le au moins un capteur (11, 11', 11", 13, 18, 12, 12', 12", 14, 19) présente en outre une troisième couche d'électrodes (7) électro-conductrice, qui est disposée dans une zone de l'élément de commande utilisateur manuelle (8) portatif, qui est adaptée à recouvrir au moins en partie un doigt (15, 16, 17, 20, 21) ou une surface intérieure de main (24) d'un utilisateur et dans lequel cette zone i) est identique à une zone de l'élément de commande utilisateur manuelle (8) portatif dans laquelle la première couche d'électrodes (1, 1') est disposée, ou ii) identique à une zone de l'élément de commande utilisateur manuelle (8) portatif dans laquelle la deuxième couche d'électrodes (2) est disposée,
**caractérisé en ce que** le au moins un capteur (11, 11', 11", 13, 18, 12, 12', 12", 14, 19) est conçu de sorte que lorsque la première zone se rapproche de la deuxième zone jusqu'au toucher, et également lorsqu'une pression est exercée ensuite, la capacité ou la résistance change de manière définie en fonction de la distance.

2. Elément de commande utilisateur manuelle (8) selon la revendication 1, **caractérisé en ce que** la surface du premier doigt (15, 16, 17, 20, 21) et/ou du deuxième doigt (15, 16, 17, 20, 21) est orientée en direction de la surface intérieure de main de l'utilisateur et/ou est orientée en direction d'un doigt voisin (15, 16, 17, 20, 21) de l'utilisateur.

3. Elément de commande utilisateur manuelle (8) selon l'une quelconque des revendications précédentes, **caractérisé en ce que** la première (1, 1') et/ou deuxième (2) couche d'électrodes électro-conductrice, éventuellement d'autres couches d'électrodes du au moins un capteur (11, 11', 11", 13, 18, 12, 12', 12", 14, 19), présente une surface profilée ou présente au moins une cavité entre la première (1, 1') et deuxième couche d'électrodes (2), et éventuellement en direction de la couche diélectrique (3, 3', 3").

4. Elément de commande utilisateur manuelle (8) selon l'une quelconque des revendications précédentes, **caractérisé en ce que**
i) la troisième couche d'électrodes (7) est disposée à côté de la première couche d'électrodes (1, 1') et éventuellement la couche diélectrique (3, 3', 3") est disposée sur la première (1, 1') et troisième couche d'électrodes (7) ou sur la deuxième couche d'électrodes (2) ; ou
ii) la troisième couche d'électrodes (7) est disposée à côté de la deuxième couche d'électrodes (2) et éventuellement la couche diélectrique (3, 3', 3") est disposée sur la deuxième (2) et troisième couche d'électrodes (7) ou sur la première couche d'électrodes (1, 1').

5. Elément de commande utilisateur manuelle (8) selon la revendication précédente, **caractérisé en ce que** le au moins un capteur (11, 11', 11", 13, 18, 12, 12', 12", 14, 19)
i) présente une quatrième (22), éventuellement encore d'autres (23) couche(s) d'électrodes électro-conductrice(s), qui sont disposées de préférence à côté de la première (1, 1') et/ou troisième couche d'électrodes (7) ; et/ou
ii) une autre couche diélectrique (3, 3', 3"), éventuellement plusieurs autres couches diélectriques (3, 3', 3") ; et/ou
iii) contient une couche de protection (5, 5', 5", 6, 6', 6") électrique, qui est disposée sur le au moins un capteur (11, 11', 11", 13, 18, 12, 12', 12", 14, 19) en direction d'une surface d'une main d'un utilisateur, dans lequel la couche de protection (5, 5', 5", 6, 6', 6") contient de préférence une couche d'électrodes (5, 5', 5") électro-conductrice et une couche diélectrique (6, 6', 6") ou est constituée de celle-ci et la couche d'électrodes (5, 5', 5") électro-conductrice est disposée en direction d'une surface d'une main d'un utilisateur.

6. Elément de commande utilisateur manuelle (8) selon l'une quelconque des revendications précédentes, **caractérisé en ce que** l'élément de commande utilisateur manuelle (8) portatif contient un matériau électriquement non conducteur, de préférence un matériau électriquement non conducteur sélectionné dans le groupe constitué de textile, cuir, similicuir, plastique et de combinaisons de ceux-ci, de manière particulièrement préférée un plastique, mieux encore un plastique élastomère, dans lequel le plastique élastomère est sélectionné en particulier dans le groupe constitué de
i) silicone, fluorosilicone, polyuréthane, polynorbornène, caoutchouc, caoutchouc naturel, caoutchouc fluoré, styrène-butadiène, isobutylène-isoprène, terpolymère éthylène-propylène-diène, poly-chlorobutadiène, polyéthylène chlorosulfoné, acrylonitrile-butadiène, acrylonitrile-butadiène hydrogéné et des combinaisons de ceux-ci ;
ii) copolymères styrène thermoplastiques, de manière particulièrement préférée sélectionnés dans le groupe constitué de copolymère styrène-butadiène-styrène, copolymère styrène-éthylène-butadiène-styrène, copolymère styrène-éthylène-propylène-styrène, copolymère styrène-éthylène-éthylène-propylène-styrène, copolymère styrène-isoprène-styrène et combinaisons de ceux-ci ;
iii) mélanges en partie réticulés à base de polyoléfine, de préférence sélectionnés dans le groupe constitué de caoutchouc éthylène-propylène-diène et polypropylène, caoutchouc nitrile-butadiène et polypropylène, caoutchouc éthylène-propylène-diène et polyéthylène et combinaisons de ceux-ci ;
iv) copolymères uréthane thermoplastiques, de préférence sélectionnés dans le groupe constitué de TPU-ARES, TPUARET, TPU-AREE et combinaisons de ceux-ci ; et
v) combinaisons de ceux-ci.

7. Elément de commande utilisateur manuelle (8) selon l'une quelconque des revendications précédentes, **caractérisé en ce que** la première couche d'électrodes (1, 1') électro-conductrice, la deuxième couche d'électrodes (2) électro-conductrice et/ou la couche diélectrique (3, 3', 3"), éventuellement d'autres couches d'électrodes (7, 22, 23) et/ou couches diélectriques (3, 3', 3") du au moins un capteur (11, 11', 11", 13, 18, 12, 12', 12", 14, 19), contient un matériau électriquement nonconducteur, de préférence un plastique, de manière particulièrement préférée un plastique élastomère, mieux encore un plastique élastomère sélectionné dans le groupe constitué de
i) silicone et ses dérivés, polyuréthane, polynorbornène, caoutchouc, caoutchouc naturel, caoutchouc fluoré, styrène-butadiène, isobutylène-isoprène, terpolymère éthylène-propylène-diène, poly-chlorobutadiène, polyéthylène chlorosulfoné, acrylonitrile-butadiène, acrylonitrile-butadiène hydrogéné et des combinaisons de ceux-ci, de préférence silicone et ses dérivés ;
ii) copolymères styrène thermoplastiques, de manière particulièrement préférée sélectionnés dans le groupe constitué de copolymère styrène-butadiène-styrène, copolymère styrène-éthylène-butadiène-styrène, copolymère styrène-éthylène-propylène-styrène, copolymère styrène-éthylène-éthylène-propylène-styrène, copolymère styrène-isoprène-styrène et combinaisons de ceux-ci ;
iii) mélanges en partie réticulés à base de polyoléfine, de préférence sélectionnés dans le groupe constitué de caoutchouc éthylène-propylène-diène et polypropylène, caoutchouc nitrile-butadiène et polypropylène, caoutchouc éthylène-propylène-diène et polyéthylène et combinaisons de ceux-ci ;
iv) copolymères uréthane thermoplastiques, de préférence sélectionnés dans le groupe constitué de TPU-ARES, TPUARET, TPU-AREE et combinaisons de ceux-ci ; et
v) combinaisons de ceux-ci.

8. Elément de commande utilisateur manuelle (8) selon l'une quelconque des revendications précédentes, **caractérisé en ce que** la première couche d'électrodes (1, 1') électro-conductrice et/ou la deuxième couche d'électrodes (2) électro-conductrice, éventuellement d'autres couches d'électrodes (7, 22, 23) du au moins un capteur (11, 11', 11", 13, 18, 12, 12', 12", 14, 19), contient un matériau électro-conducteur, de préférence un matériau sélectionné dans le groupe constitué de carbone, métal, semi-métal, plastique électro-conducteur et des mélanges de ceux-ci, de manière particulièrement préférée un matériau sélectionné dans le groupe constitué de noir de carbone, graphite, graphène, nanotube de carbone, fer, cuivre, argent, or, polyaniline, polyacétylène, polypyrrole, polyparaphénylène, polythiophène et des combinaisons de ceux-ci, dans lequel le matériau mieux encore est présent dans une forme anisotrope, en particulier dans une forme sélectionnée dans le groupe constitué de particules, plaquettes, bâtonnets, fibres et combinaisons de ceux-ci.

9. Elément de commande utilisateur manuelle (8) selon l'une quelconque des revendications précédentes, **caractérisé en ce que** la couche diélectrique (3, 3', 3") contient un matériau pouvant être polarisé électriquement, de préférence un matériau sélectionné dans le groupe constitué de titanate de baryum, titanate zirconate de plomb, dioxyde de titane et des mélanges de ceux-ci, dans lequel le matériau mieux encore est présent dans une forme anisotrope, en particulier dans une forme sélectionnée dans le groupe constitué de particules, plaquettes, bâtonnets, fibres et combinaisons de ceux-ci.

10. Elément de commande utilisateur manuelle (8) selon l'une quelconque des revendications précédentes, **caractérisé en ce que** l'unité de commande électronique est configurée pour convertir une capacité électrique détectée par le capteur (11, 11', 11", 13, 18, 12, 12', 12", 14, 19) et/ou une résistance électrique détectée par le capteur (11, 11', 11", 13, 18, 12, 12', 12", 14, 19) en
i) une grandeur de commande continue pour la commande continue d'un dispositif à commande électrique ; et/ou
ii) une grandeur de commande étagée pour la commutation étagée d'un dispositif à commande électrique, de préférence une grandeur de commande binaire pour la commutation binaire d'un dispositif à commande électrique, dans lequel l'unité de commande électronique est configurée de préférence
pour réaliser la conversion en la grandeur de commande étagée par une comparaison d'au moins une valeur détectée par le capteur (11, 11', 11", 13, 18, 12, 12', 12", 14, 19) pour la capacité électrique et/ou la résistance électrique à au moins une valeur seuil, en particulier sur la base d'un dépassement ou passage au-dessous d'une valeur seuil ou sur la base d'une action consistant à déterminer si la au moins une valeur détectée par le capteur (11, 11', 11", 13, 18, 12, 12', 12", 14, 19) se situe dans un intervalle entre deux valeurs seuil et/ou
pour réaliser la conversion en la grandeur de commande étagée par prise en compte d'une ou de plusieurs valeur(s) détectée(s) par le capteur (11, 11', 11", 13, 18, 12, 12', 12", 14, 19) pour la capacité électrique et/ou la résistance électrique dans une fonction mathématique ; et/ou
iii) pour convertir un signal pour la réception d'une grandeur de commande continue ou étagée définie du dispositif électrique.

11. Elément de commande utilisateur manuelle (8) selon l'une quelconque des revendications précédentes, **caractérisé en ce que** l'interface de communication est configurée pour envoyer sans fil le signal de commande de l'unité de commande électronique à un dispositif à commande électrique, de préférence par l'intermédiaire d'un signal sans fil sélectionné dans le groupe constitué de Bluetooth, WLAN, ZigBee, Z-Wave, Thread, 2G, 3G, 4G, 5G, LTE et des combinaisons de ceux-ci.

12. Kit contenant un élément de commande utilisateur manuelle (8) selon l'une quelconque des revendications précédentes et un dispositif à commande électrique, dans lequel le dispositif à commande électrique est configuré pour recevoir au moins un signal de commande de l'unité de commande électronique de l'élément de commande utilisateur manuelle (8) portatif et être commandé par celui-ci.

13. Utilisation de l'élément de commande utilisateur manuelle (8) selon l'une quelconque des revendications 1 à 11 pour la commande d'un dispositif à commande électrique, dans laquelle il s'agit pour le dispositif à commande électrique de préférence
i) d'un appareil ménager, de préférence un appareil ménager sélectionné dans le groupe constitué d'une machine à laver, d'un ustensile de cuisine, aspirateur, d'une tondeuse à gazon et de combinaisons de ceux-ci, contient ou est constitué de ceux-ci ; et/ou
ii) il s'agit d'un robot, de préférence d'un robot dans le domaine privé ou d'un robot industriel ; et/ou
iii) il s'agit d'un véhicule routier ou véhicule aquatique, dans laquelle la commande concerne en particulier une ouverture de portes, fermeture de portes, un éclairage, un réglage de rétroviseurs, une climatisation, une navigation et/ou une électronique grand public ; et/ou
iv) il s'agit d'un objet volant, de préférence d'un drone ; et/ou
v) il s'agit d'un ordinateur, de préférence d'un ordinateur sélectionné dans le groupe constitué d'un PC, ordinateur portable, une tablette, un smartphone et des combinaisons de ceux-ci ; et/ou
vi) il s'agit d'une interface d'entrée pour un ordinateur, de préférence d'un manche à balai, une souris, un clavier et des combinaisons de ceux-ci ; et/ou
vii) il s'agit d'un véhicule logistique ; et/ou
viii) il s'agit d'une machine de production ; et/ou
ix) il s'agit d'une bande transporteuse ; et/ou
x) il s'agit d'un composant d'électronique grand public, de préférence sélectionné dans le groupe constitué d'un téléviseur, de systèmes audio, d'un vidéoprojecteur, d'une caméra, d'un lecteur MP3, haut-parleur, casque, d'une console de jeu et de combinaisons de ceux-ci ; et/ou
xi) il s'agit d'un composant de domotique, de préférence d'un composant de domotique sélectionné dans le groupe constitué d'un système de chauffage, système de climatisation, système de protection solaire et de combinaisons de ceux-ci ; et/ou
xii) il s'agit de lunettes de réalité virtuelle/réalité augmentée, dans laquelle la commande concerne en particulier des fonctions électroniques représentées sur les lunettes de réalité virtuelle/réalité augmentée ;
dans laquelle la commande du dispositif à commande électrique s'effectue par une réunion des deux zones de l'élément de commande utilisateur manuelle (8) portatif.
